# EUROPÄISCHE PATENTANMELDUNG

(11) **EP 3 229 566 A1**
(43) Veröffentlichungstag der Anmeldung: **11.10.2017**
(21) Anmeldenummer: 17165000.5
(22) Anmeldetag: 05.04.2017
(51) Int. Cl.: H05K 3/34, H05K 3/40, H05K 1/02, H05K 1/11, H05K 3/32

(54) **VERBINDUNGSELEMENT FÜR EINE ELEKTRONISCHE BAUELEMENTANORDNUNG UND VERFAHREN ZUM HERSTELLEN DESSELBEN, ELEKTRONISCHE BAUELEMENTANORDNUNG UND VERFAHREN ZUM HERSTELLEN DESSELBEN**

(30) Priorität: 08.04.2016 DE 102016106482
(71) Anmelder: BIOTRONIK SE & Co. KG, 12359 Berlin (DE)
(72) Erfinder: Henschel, Martin, 13125 Berlin (DE)
(74) Vertreter: Keck, Hans-Georg

(57) **Zusammenfassung**

Die Erfindung betrifft ein Verbindungselement (1) für eine elektronische Bauelementanordnung, aufweisend einen Träger (2), ein erstes Kontaktpad (3) und ein zweites Kontaktpad (4), eine das erste Kontaktpad (3) und das zweite Kontaktpad (4) elektrisch leitend miteinander verbindende elektrisch leitfähige Struktur (5) und einen ersten Kontaktleiter (6), der mittels einer Lotschicht (11) mit dem ersten Kontaktpad (3) elektrisch leitend verbunden ist und der in einem zweiten Abschnitt der ersten Oberfläche (61) und/oder auf der zweiten Oberfläche (62) zum Ausbilden einer Schweißverbindung ausgestaltet ist. Die Erfindung betrifft ferner eine elektronische Bauelementanordnung mit einem solchen Verbindungselement und mit zumindest einem an den Kontaktleiter geschweißten Bauelement und die Verfahren zum Herstellen des Verbindungselements und der Bauelementanordnung.

## Beschreibung

Die Erfindung betrifft ein Verbindungselement für eine elektronische Bauelementanordnung, insbesondere für einen implantierbaren Defibrillator oder Herzschrittmacher, und ein Verfahren zum Herstellen eines solchen Verbindungselements für eine elektronische Bauelementanordnung. Ferner betrifft die Erfindung eine elektronische Bauelementanordnung, insbesondere einen implantierbaren Defibrillator oder Herzschrittmacher, mit einem solchen Verbindungselement sowie ein Verfahren zum Herstellen einer solchen elektronischen Bauelementanordnung.

In verschiedenen Technologiegebieten besteht Bedarf nach immer kleineren elektronischen Geräten. Dies setzt eine stetig fortschreitende Verkleinerung der elektrischen Schaltkreise und einen immer höheren Integrationsgrad der Geräte selbst voraus. Neben der immer weiter zunehmenden Miniaturisierung der aktiven Schaltungsbauteile macht dies auch die Verkleinerung von deren Verbindungselementen erforderlich. Je nach Einsatzgebiet der elektronischen Geräte bestehen zudem Einschränkungen bezüglich der zur Fertigung der Schaltungsbauteile und der Verbindungselemente sowie für deren Montage zulässigen Verfahrenstechniken. Dies erschwert die Verwendung von aus der Mikroelektronik bekannten Fertigungsverfahren oder erfordert zumindest deren Anpassung.

Bei der Herstellung von implantierbaren elektronischen Geräten, wie beispielsweise von implantierbaren Defibrillatoren oder Herzschrittmachern, die in der Regel ein flüssigkeitsdichtes, biokompatibles Gehäuse und eine darin angeordnete elektronische Bauelementanordnung aufweisen, werden bislang vor allem schweißbare Verdrahtungsbänder zum Verbinden der einzelnen Bauelemente der Bauelementanordnung verwendet. Diese Verdrahtungsbänder bestehen aus metallischen Leitern, die beidseitig mit einer Isolationsfolie laminiert sind. Designeinschränkungen ergeben sich dabei nicht nur aufgrund von Kriechund Luftstrecken, die aus Gründen der elektrischen Isolierung einzuhalten sind, sondern auch da eine zuverlässige Laminierung der Folien relativ hohe Mindestabstände der Leiter, beispielsweise von bis zu 0,6 mm, erfordert.

Ein weiterer Nachteil der bekannten Verdrahtungsbänder ist, dass keine sich kreuzenden Leiterbahnen in einem Verdrahtungsband realisiert werden können. Zudem treten aufgrund der laminierten Folien beim Biegen der Verdrahtungsbänder Rückstellkräfte auf, die ein freies Verformen der Bänder erschweren. Diese Rückstellkräfte verringern nicht nur die Passgenauigkeit verformter Bänder, sondern führen in bestimmten Einbausituationen auch zu mechanischen Spannungen. Aufgrund der laminierten metallischen Leiter sind die Bänder insgesamt wenig flexibel und nur sehr beschränkt zum Toleranzausgleich geeignet. All dies wirkt sich nachteilig auf die dauerhafte Leitfähigkeit elektrischer Kontakte aus und kann, beispielweise bei Vibrationen, sogar zum Abriss von Kontakten einer Bauelementanordnung führen. Dies ist bei medizinischen Implantaten wie Defibrillatoren oder Herzschrittmachern unbedingt zu vermeiden.

Die Fertigung der Bänder erfolgt in der Regel Batch-weise, wobei die Bänder nacheinander händisch in verschiedene Umformwerkzeuge eingelegt werden müssen. Mit diesen zeit- und kostenintensiven Prozessen sind gängige Anforderungen an Passgenauigkeit und Sauberkeit, wie sie beispielsweise implantierbare Geräte erfüllen müssen, nur schwer zu erfüllen. Dies führt insbesondere bei der Produktion von medizinischen Implantaten zu relativ hohen Ausschusszahlen und ist daher wirtschaftlich nachteilig.

In der Mikroelektronik werden häufig Drahtbondverfahren zum elektrischen Kontaktieren von elektronischen Bauelementen mit tragenden Substraten beziehungsweise deren Leiterbahnen oder Kontaktpads eingesetzt. Als Kontaktleiter kommen dabei in der Regel dünne Aluminiumdrähte zum Einsatz, die an Substrat und Bauteil gelötet oder geschweißt werden. Da beim Niederhalten und Anschweißen der Bonddrähte hohe Kräfte auftreten, setzt das Bonden die Verwendung spezieller Niederhalter sowie das Fixieren der Substrate voraus. Flexible Substrate, insbesondere in nicht-planaren Einbaulagen, lassen sich jedoch nur schwer fixieren. Eine Fixierung kann beispielsweise erreicht werden, indem elektronische Bauelemente vor dem Kontaktieren mittels des flexiblen Trägers in ein Gehäuse eingeklebt werden. Bei der Herstellung implantierbarer elektronischer Geräte ist die Verwenden von Klebstoffen nachteilig, da Ausdünstungen des Klebers ein gesundheitliches Risiko darstellen und sich auf das elektronische Verhalten des Implantats negativ auswirken.

Die Aufgabe der vorliegenden Erfindung ist es daher, die Nachteile des Standes der Technik zu überwinden und ein Verbindungselement für eine elektronische Bauelementanordnung bereitzustellen, das insbesondere in implantierbaren elektronischen Geräten verwendet werden kann. Das Verbindungselement soll ferner mittels automatisierter Verfahren kostengünstig und mit hoher Passgenauigkeit herstellbar sein, als Halbzeug vorgehalten werden können und zum elektrisch leitfähigen Verbinden einer Vielzahl von Bauelementen einsetzbar sein.

Diese Aufgabe wird gelöst durch ein Verbindungselement für eine elektronische Bauelementanordnung, durch eine elektronische Bauelementanordnung sowie durch ein Verfahren zum Herstellen derselben gemäß den unabhängigen Patentansprüchen. Bevorzugte Weiterbildungen sind jeweils Gegenstand der rückbezogenen Unteransprüche.

In einer ersten Ausführungsform der Erfindung weist ein Verbindungselement für eine elektronische Bauelementanordnung einen Träger mit einer ersten Hauptoberfläche und einer der ersten Hauptoberfläche gegenüberliegenden zweiten Hauptoberfläche auf. Auf einer der Hauptoberflächen des Trägers ist ein erstes Kontaktpad und auf einer der Hauptoberflächen des Trägers ist ein zweites Kontaktpad angeordnet. Das erste Kontaktpad und das zweite Kontaktpad sind über eine elektrisch leitfähige Struktur elektrisch leitend miteinander verbunden. Das Verbindungselement weist ferner einen ersten Kontaktleiter mit einer ersten Oberfläche und einer der ersten Oberfläche gegenüberliegenden zweiten Oberfläche auf. Der erste Kontaktleiter weist einen ersten Abschnitt und einen mit diesem nicht überlappenden zweiten Abschnitt auf. Der erste Abschnitt der ersten Oberfläche ist dabei über dem ersten Abschnitt der zweiten Oberfläche angeordnet und der zweite Abschnitt der ersten Oberfläche ist dabei über dem zweiten Abschnitt der zweiten Oberfläche angeordnet. Ein erster Abschnitt der ersten Oberfläche des ersten Kontaktleiters ist über eine Lotschicht mit dem ersten Kontaktpad elektrisch leitend verbunden und der erste Kontaktleiter ist in einem zweiten Abschnitt der ersten Oberfläche und/oder auf der zweiten Oberfläche zum Ausbilden einer Schweißverbindung ausgestaltet.

Der Begriff "gegenüberliegend" ist in diesem Zusammenhang so zu verstehen, dass die erste Oberfläche dabei einen Flächennormalenvektor aufweist, der zu einem Flächennormalenvektor der gegenüberliegenden zweiten Oberfläche zumindest im Wesentlichen entgegengesetzt ausgerichtet ist, wobei beide Flächennormalenvektoren voneinander weg zeigen. In einer ebenfalls bevorzugten Ausführungsform sind alle Flächennormalenvektoren der ersten Oberfläche im Wesentlichen parallel zueinander und sind alle Flächennormalenvektoren der zweiten Oberfläche im Wesentlichen parallel zueinander. Der Begriff "über" bedeutet in diesem Zusammenhang, dass ein rückwärts verlängerter Flächennormalenvektor des ersten Abschnitts der ersten Oberfläche des ersten Kontaktleiters den ersten Abschnitt der zweiten Oberfläche des ersten Kontaktleiters schneidet.

Gemäß dieser Ausführungsform der Erfindung ist der erste Kontaktleiter an einem ersten Kontaktpad des Trägers angelötet und zumindest abschnittsweise zum Ausbilden einer Schweißverbindung ausgestaltet. Der erste Kontaktleiter ist somit zumindest abschnittsweise schweißbar ausgestaltet, so dass zwischen diesen Abschnitten und einem anderen Bauelement eine Schweißverbindung hergestellt werden kann, die ihre bestimmungsgemäße Aufgabe, insbesondere das elektrische Kontaktieren von dem ersten Kontaktleiter mit dem anderen Bauelement, über eine bestimmte Gebrauchsdauer erfüllen kann. Die Schweißbarkeit des ersten Kontaktleiters, insbesondere der zweiten Oberfläche des ersten Kontaktleiters und/oder des zweiten Abschnitts der ersten Oberfläche des ersten Kontaktleiters umfasst dabei insbesondere die Schweißeignung, die Schweißmöglichkeit und die Schweißsicherheit dieser Abschnitte des ersten Kontaktleiters. Das Verbindungselement dieser Ausführungsform kann vorteilhaft in einem automatisierten Lötprozess mit einem ersten Kontaktleiter bestückt, als Halbzeug vorgehalten und in einem automatisierten Schweißprozess mit einem zu kontaktierenden Bauteil elektrisch leitend verbunden werden. Weitere zu kontaktierende Bauteile können auf gleiche Weise oder anderweitig, beispielsweise über Lötverbindungen oder Steckverbindungen, mit dem Verbindungselement kontaktiert werden.

Die Schweißeignung des ersten Kontaktleiters bezieht sich dabei auf die Werkstoffeigenschaft des ersten Kontaktleiters bei Anwendung eines Schweißverfahrens auf dessen zweite Oberfläche und/oder auf den zweiten Abschnitt von dessen erster Oberfläche eine untrennbare Verbindung mit einem anderen oder demselben Werkstoff einzugehen. Die Schweißeignung des ersten Kontaktleiters kann dabei in Abhängigkeit von dem eingesetzten Schweißverfahren variieren. In einer bevorzugten Ausführungsform weist der erste Kontaktleiter, insbesondere im Bereich seiner zweiten Oberfläche und/oder im Bereich des zweiten Abschnitts seiner ersten Oberfläche, Schweißeignung im Hinblick auf Laserschweißen auf. In einer ebenfalls bevorzugten Ausführungsform weist der erste Kontaktleiter, insbesondere im Bereich seiner zweiten Oberfläche und/oder im Bereich des zweiten Abschnitts seiner ersten Oberfläche, Schweißeignung im Hinblick auf Widerstandsschweißen, beziehungsweise eine dafür ausreichend geringe thermische und elektrische Leitfähigkeit, auf. Die für den ersten Kontaktleiter bevorzugten Materialen werden untenstehend näher erläutert.

Die Schweißmöglichkeit des ersten Kontaktleiters setzt voraus, dass ein Schweißverfahren an der zweiten Oberfläche des ersten Kontaktleiters und/oder an dem zweiten Abschnitt der ersten Oberfläche des ersten Kontaktleiters bauraumbedingt durchführbar ist. Insbesondere weist der erste Kontaktleiter eine Anordnung auf dem Träger und eine geometrische Gestalt auf, welche die Durchführung eines Schweißverfahrens in den vorab genannten Abschnitten problemlos ermöglichen. Die Schweißmöglichkeit kann in Abhängigkeit des eingesetzten Schweißverfahrens variieren. In einer bevorzugten Ausgestaltung weist der erste Kontaktleiter auf seiner zweiten Oberfläche und/oder im zweiten Abschnitt seiner ersten Oberfläche Schweißeignung für Laserschweißen oder Widerstandsschweißen auf. Die für den ersten Kontaktleiter bevorzugte Anordnung und Gestalt werden untenstehend näher erläutert.

Die Schweißsicherheit des ersten Kontaktleiters setzt voraus, dass dieser so dimensioniert ist, dass eine Schweißverbindung ausgebildet werden kann, die den zu erwartenden Beanspruchungen und Spannungen über eine bestimmte Gebrauchsdauer standhält. Somit weist der erste Kontaktleiter insgesamt eine Ausdehnung und ein Volumen auf, die das Ausbilden einer dauerhaften Schweißverbindung im Bereich von dessen zweiter Oberfläche und/oder im Bereich des zweiten Abschnitts von dessen erster Oberfläche ermöglichen. Die Schweißmöglichkeit kann in Abhängigkeit des eingesetzten Schweißverfahrens variieren. In einer bevorzugten Ausgestaltung weist der erste Kontaktleiter auf seiner zweiten Oberfläche und/oder im zweiten Abschnitt seiner ersten Oberfläche Schweißmöglichkeit für Laserschweißen oder Widerstandsschweißen auf. Die für den ersten Kontaktleiter bevorzugte Dimensionierung wird untenstehend näher erläutert.

In einer bevorzugten Ausführungsform der Erfindung ist der erste Abschnitt des ersten Kontaktleiters über dem ersten Kontaktpad angeordnet und ist in dem ersten Abschnitt die erste Oberfläche des ersten Kontaktleiters dem ersten Kontaktpad zugewandt. Dabei können eine oder mehrere zusätzliche Schichten zwischen dem Kontaktpad und dem ersten Abschnitt des ersten Kontaktleiters angeordnet sein. Diese Relativanordnung ermöglicht ein einfaches Ausbilden einer Lotschicht zwischen dem Kontaktpad und dem ersten Abschnitt der ersten Oberfläche des ersten Kontaktleiters zum Herstellen einer elektrisch leitfähigen Verbindung zwischen Kontaktpad und erstem Kontaktleiter.

In dieser Ausführungsform der Erfindung ist zudem der zweite Abschnitt der ersten Oberfläche des ersten Kontaktleiters nicht über dem ersten Kontaktpad angeordnet, beispielsweise in dem er seitlich über dieses übersteht. Zusätzlich oder alternativ ist der zweite Abschnitt der ersten Oberfläche des ersten Kontaktleiters dem ersten Kontaktpad nicht zugewandt, beispielsweise indem dieser zu dem ersten Abschnitt oder dem ersten Kontaktpad einen rechten Winkel aufweist. In einer bevorzugten Ausführungsform ist der zweite Abschnitt der ersten Oberfläche des ersten Kontaktleiters nicht über einer Hauptoberfläche des Trägers angeordnet, beispielsweise in dem dieser seitlich über diesen übersteht. Dabei kann der erste Kontaktleiter über einen seitlichen Rand des Trägers oder über den Rand einer Öffnung im Träger überstehen. Ebenfalls bevorzugt ist der zweite Abschnitt der ersten Oberfläche des ersten Kontaktleiters einer Hauptoberfläche des Trägers nicht zugewandt, beispielsweise indem dieser zu dem ersten Abschnitt oder dem Träger einen rechten Winkel aufweist. In beiden Varianten ist der zweite Abschnitt der ersten Oberfläche des ersten Kontaktleiters nicht mittels einer Lotschicht mit dem ersten Kontaktpad verbunden. Der erste Kontaktleiter weist in dieser Ausführungsform eine verbesserte Schweißbarkeit und insbesondere eine verbesserte Schweißmöglichkeit im Bereich des zweiten Abschnitts seiner ersten Oberfläche auf.

Der Begriff "zugewandt" bedeutet in diesem Zusammenhang, dass der Flächennormalenvektor des ersten Kontaktpads und der Flächennormalenvektor des ersten Abschnitts der ersten Oberfläche im Wesentlichen entgegengesetzt ausgerichtet sind, wobei beide Flächennormalenvektoren aufeinander zu zeigen. Der Begriff "über" bedeutet in diesem Zusammenhang, dass ein Flächennormalenvektor der Oberfläche des ersten Kontaktpads den ersten Abschnitt des ersten Kontaktleiters schneidet.

In einer weiteren Ausführungsform der Erfindung weist das Verbindungselement ferner einen zweiten Kontaktleiter mit einer ersten Oberfläche und einer der ersten Oberfläche gegenüberliegenden zweiten Oberfläche auf, wobei ein erster Abschnitt der ersten Oberfläche des zweiten Kontaktleiters über eine Lotschicht mit dem zweiten Kontaktpad elektrisch leitend verbunden ist und wobei der zweite Kontaktleiter in einem zweiten Abschnitt der ersten Oberfläche und/oder auf der zweiten Oberfläche zum Ausbilden einer Schweißverbindung ausgestaltet ist. Bezüglich der Schweißbarkeit, insbesondere der Schweißeignung, der Schweißmöglichkeit und der Schweißsicherheit, des zweiten Kontaktleiters gilt das für den ersten Kontaktleiter ausgeführte. Das Verbindungselement gemäß dieser Ausführungsform kann vorteilhaft in einem automatisierten Lötprozess mit einem ersten und einem zweiten Kontaktleiter bestückt, als Halbzeug vorgehalten und in einem automatisierten Schweißprozess mit zwei zu verbindenden Bauteilen elektrisch leitend verbunden werden.

In einer anderen Ausführungsform ist der erste Abschnitt des zweiten Kontaktleiters über dem zweiten Kontaktpad angeordnet und ist der erste Abschnitt der ersten Oberfläche des zweiten Kontaktleiters dem zweiten Kontaktpad zugewandt. Dabei können eine oder mehrere Schichten zwischen dem zweiten Kontaktpad und dem ersten Abschnitt des zweiten Kontaktleiters angeordnet sein. Diese Relativanordnung ermöglicht ein einfaches Ausbilden einer Lotschicht zwischen dem Kontaktpad und dem ersten Abschnitt der ersten Oberfläche des zweiten Kontaktleiters zum Herstellen einer elektrisch leitfähigen Verbindung zwischen zweitem Kontaktpad und zweitem Kontaktleiter.

In dieser Ausführungsform der Erfindung ist zudem der zweite Abschnitt der ersten Oberfläche des zweiten Kontaktleiters nicht über dem zweitem Kontaktpad angeordnet, beispielsweise in dem er seitlich über dieses übersteht. Zusätzlich oder alternativ ist der zweite Abschnitt der ersten Oberfläche des zweiten Kontaktleiters dem zweiten Kontaktpad nicht zugewandt, beispielsweise indem er zu dem ersten Abschnitt oder dem zweiten Kontaktpad einen rechten Winkel aufweist. In einer bevorzugten Ausführungsform ist der zweite Abschnitt der ersten Oberfläche des zweiten Kontaktleiters nicht über einer Hauptoberfläche des Trägers angeordnet ist, beispielsweise in dem er seitlich über diesen übersteht. Dabei kann der zweite Kontaktleiter über einen seitlichen Rand des Trägers oder über den Rand einer Öffnung im Träger überstehen. Ebenfalls bevorzugt ist der zweite Abschnitt der ersten Oberfläche des zweiten Kontaktleiters einer Hauptoberfläche des Trägers nicht zugewandt, beispielsweise indem er zu dem ersten Abschnitt oder dem Träger einen rechten Winkel aufweist. In beiden Varianten ist der zweite Abschnitt der ersten Oberfläche des zweiten Kontaktleiters nicht über eine Lotschicht mit dem zweiten Kontaktpad verbunden. Der zweite Kontaktleiter weist in dieser Ausführungsform eine verbesserte Schweißbarkeit und insbesondere eine verbesserte Schweißmöglichkeit im Bereich des zweiten Abschnitts seiner ersten Oberfläche auf.

In einer weiterhin bevorzugten Ausführungsform der Erfindung weist das Verbindungselement eine Mehrzahl, also zumindest zwei, erster Kontaktpads und eine Mehrzahl zweiter Kontaktpads auf. Die genaue Anzahl erster und zweiter Kontaktpads hängt von der Anzahl mittels des Verbindungselements zu kontaktierender Bauelemente sowie von der Anzahl der Kontaktstellen dieser Bauelemente ab. Das Verbindungselement dieser Ausführungsform weist ferner eine Mehrzahl elektrisch leitfähiger Strukturen zum elektrisch leitfähigen Verbinden von ersten und zweiten Kontaktpads auf, wobei jede elektrisch leitfähige Struktur zumindest ein erstes Kontaktpad mit zumindest einem zweiten Kontaktpad elektrisch leitend verbindet. Ferner weist das Verbindungselement eine Mehrzahl erster Kontaktleiter und eine Mehrzahl zweiter Kontaktleiter auf, die wie obenstehend beschrieben ausgebildet sind und wie obenstehend beschrieben jeweils mittels einer Lotschicht elektrisch leitend mit einem ersten beziehungsweise zweiten Kontaktpad verbunden sind. Diese Ausführungsform ermöglicht die Verwendung eines Verbindungselements zum Verbinden eines oder mehrerer elektronischer Bauelemente miteinander und/oder mit einer elektrischen Strom-/ oder Spannungsquelle.

In einer Ausführungsform der Erfindung sind der erste beziehungsweise (und/oder) zweite Kontaktleiter aus Nickel, Kupfer, Tantal, Niob, Aluminium oder Legierungen davon gebildet. Alternativ weist der erste beziehungsweise zweite Kontaktleiter in einem zweiten Abschnitt von deren erster Oberfläche und/oder auf deren zweiter Oberfläche eine Beschichtung aus Nickel, Kupfer, Tantal, Niob, Aluminium oder Legierungen davon auf. Diese Materialien ermöglichen das Herstellen einer langzeitstabilen Schweißverbindung und erhöhen somit die Schweißeignung der Kontaktleiter. Bevorzugt ist der erste beziehungsweise zweite Kontaktleiter aus Nickel gebildet oder mit Nickel beschichtet.

In einer ebenfalls bevorzugten Ausführungsform der Erfindung ist der erste beziehungsweise zweite Kontaktleiter des Verbindungselements als ein flaches Metallband, eine Metallfolie oder ein Metallquader ausgebildet. Ein Kontaktleiter in Form eines Metallbands oder einer Metallfolie weist dabei eine Höhe auf, die im Verhältnis zu Länge und Breite des Kontaktleiters gering ist und bevorzugt weniger als ein Zehntel, besonders bevorzugt weniger als ein Zwanzigstel von diesen beträgt. Ein Kontaktleiter in Form eines Metallquaders weist eine Höhe derselben Größenordnung wie Länge und Breite des Quaders auf und ermöglicht so beispielsweise die Realisierung von Steckverbindungen. Besonders bevorzugt ist der erste beziehungsweise zweite Kontaktleiter als Nickelband oder Nickelfolie, beispielsweise mit einer Dicke von 0,1 mm, ausgebildet. Ein Kontaktleiter in Form eines Metallbands oder eines Metallquaders weist eine hohe Schweißeignung und Schweißsicherheit auf und ist zudem formstabil.

In einer ferner bevorzugten Ausführungsform ist in dem zweiten Abschnitt des ersten Kontaktleiters eine Durchgangsöffnung von der ersten Oberfläche zu der zweiten Oberfläche des ersten Kontaktleiters angeordnet. Ebenfalls bevorzugt ist in dem zweiten Abschnitt des zweiten Kontaktleiters eine Durchgangsöffnung von der ersten Oberfläche zu der zweiten Oberfläche des zweiten Kontaktleiters angeordnet. Die genaue Lage der Durchgangsöffnung innerhalb des zweiten Abschnitts des ersten beziehungsweise zweiten Kontaktleiters und die Größe der Durchgangsöffnung können dabei variieren. Die Durchgangsöffnung ist kreisrund, oval, als Langloch oder mit einem beliebig geformten Rand ausgebildet. Die Durchgangsöffnung kann in einem automatisierten Schweißverfahren als Positionsmarke genutzt werden. Die Querschnittfläche der Durchgangsöffnungen ist bevorzugt dazu geeignet, ein Laserschweißverfahren durch die Durchgangsöffnung hindurch durchzuführen, das heißt den Durchtritt des zum Schweißen verwendeten Laserstrahls durch den Kontaktleiter hindurch zu ermöglichen. Ein Kontaktleiter mit einer solchen Durchgangsöffnung weist im zweiten Abschnitt eine verbesserte Schweißmöglichkeit auf. Ferner ist die Querschnittsfläche der Durchgangsöffnung bevorzugt dafür geeignet, ein optisches Prüfverfahren durch die Durchgangsöffnung hindurch durchzuführen, insbesondere um eine über der Durchgangsöffnung angeordnete Schweißverbindung des Kontaktleiters optisch zu prüfen. Alternativ oder zusätzlich zu der Durchgangsöffnung kann ein als Metallquader oder als Metallband ausgebildeter Kontaktleiter ein Sackloch zum Aufnehmen eines Kontaktpins eines Bauelements aufweisen, um so eine Steckverbindung mit dem Kontaktleiter zu ermöglichen.

Bei der Verwendung des Verbindungselements in einer Bauelementanordnung eines implantierbaren elektronischen Geräts, beispielsweise in einem implantierbaren Herzschrittmacher oder Defibrillator, weist der erste beziehungsweise zweite Kontaktleiter ferner einen stromführenden Querschnitt auf, der zum Leiten von Stromimpulsen von bis zu 10 A, bevorzugt von bis zu 15 A und besonders bevorzugt von bis zu 20 A geeignet ist. Mit anderen Worten kann der Kontaktleiter wiederholt einen solchen Strompuls führen, ohne dass dessen elektrische Leitfähigkeit beeinträchtigt wird. Ferner bevorzugt ist der erste beziehungsweise zweite Kontaktleiter zum Führen von elektrischen Strömen mit einer Energie von bis zu 30 Joule, bevorzugt bis zu 40 Joule und besonders bevorzugt bis zu 50 Joule ausgebildet. Ebenfalls bevorzugt sind auch Lotverbindungen zwischen Kontaktleiter und Kontaktpad und Schweißverbindungen zwischen Kontaktleiter und Bauelement zum Führen elektrischer Ströme dieser Stärke beziehungsweise Energie ausgebildet.

In einer Ausführungsform der Erfindung ist der Träger als ein flexibler Schaltungsträger, insbesondere als ein gedruckter flexibler Schaltungsträger (Printed Circuit Board - PCB), ausgebildet. Flexible Schaltungsträger sind bekannt und in der Regel aus einem flexiblen Kunststoffsubstrat als Trägermaterial und elektrisch leitfähigen Metallstrukturen gebildet. Bevorzugt ist der flexible Schaltungsträger in Dünnfilmtechnologie oder Flex-Circuit Technologie realisiert. Als flexible Kunststoffsubstrate werden dabei bevorzugt Polyimidfolien, Polyesterfolien, Polyetherketonfolien (PEEK) oder flüssigkristalline Polymere (LCP) eingesetzt. Die elektrisch leitfähigen Metallstrukturen sind bevorzugt aus Aluminium, Kupfer oder Legierungen davon gebildet. In einer bevorzugten Ausführungsform ist die elektrisch leitfähige Struktur als elektrisch leitfähige Metallstruktur zwischen der ersten und zweiten Hauptoberfläche des Trägers angeordnet. Besonders bevorzugt sind die erste und die zweite Hauptoberfläche des Trägers jeweils durch eine dünne Schicht eines dielektrischen Kunststoffs gebildet. Kontaktpads kontaktieren die elektrisch leitfähige Metallstruktur durch eine der beiden dielektrischen dünnen Schichten hindurch.

Die Verwendung eines flexiblen Schaltungsträgers hat gegenüber einem starren Substrat den Vorteil, dass einfach oder mehrfach gebogene beziehungsweise gefaltete Einbaulagen eines solchen Trägers realisierbar sind. Damit kann ein begrenzter Bauraum, beispielsweise das Gehäuse eines medizinischen Implantats, optimal genutzt werden. Ein flexibler Schaltungsträger ist zudem für Anwendungsbereiche geeignet, die eine hohe Flexibilität der Interconnect-Baugruppe erfordern, beispielsweise für einen Toleranzausgleich oder bei mechanischer Belastung der Baugruppe.

Derartige flexible Schaltungsträger sind vorzugsweise so aufgebaut, dass zwischen LCP-Filmschichten (Liquid Chrystal Polymer) sich leitfähige Leiterbahnstrukturen aus Kupfer, Gold, Platin, Niob, etc. befinden. Ein Substrat mit LCP-Filmschichten ist wegen der höheren Flexibilität durch die geringe Schichtdicke des Isolationsmaterials zu bevorzugen. Auch besitzt das Material die Eigenschaft, Wasser aufzunehmen, sodass es sich für einen Einsatz im implantierbaren Defibrillator oder Herzschrittmacher eignet, da somit so wenig Feuchtigkeit wie möglich im Implantat verbleibt und Korrosionsprozesse verhindert werden. Ebenfalls vorteilhaft ist das thermische Abfuhrverhalten des Materials. Möglich wären als Isolator auch zwei Polyimidschichten mit einer innenliegenden leitfähigen Kupferschicht. Auch wäre ein mehrschichtiger Aufbau möglich, um z.B. sich kreuzende Leiterbahnen zu realisieren. Wichtig ist die sehr gute elektrische Leitfähigkeit der Leiterbahnen. Die Leiterbahn muss in der Regel einen geringen Gesamtwiderstand aufweisen; dabei weisen leitfähige Polymere (Kunststoffe versetzt mit leitfähigen Partikeln aus Silber o.ä.) in der Regel einen um Größenordnungen höheren elektrischen Widerstand auf als z.B. Kupfer. Bei einem Defibrillator-Implantat (ICD) fließen auf diesen Konnektor-Leiterbahnen kurzzeitig sehr hohe Ströme. Ein zu großer Widerstand der Leiterbahn würde ggf. zu hohen Verlusten in der Leiterbahn führen und die Defibrillations-Therapie kann nicht effektiv durchgeführt werden.

Ferner bevorzugt ist der flexible Schaltungsträger dafür eingerichtet, einen Toleranzausgleich von +/- 3 mm, bevorzugt von +/- 2 mm und besonders bevorzugt von +/- 1 mm durch einen geometrischen Versatz in der Fläche zu gewährleisten. Beispielsweise können somit Kontaktstellen eines Bauteils, die zueinander einen Höhenversatz aufweisen, mittels eines einzigen Verbindungselements, welches einen einzigen flächigen Schaltungsträger aufweist, kontaktiert werden. Ein derartiger flexibler Schaltungsträger bleibt in seiner Einbaulage auch bei Störungen, beispielsweise Vibrationen, funktionsfähig. Insbesondere bleibt die Leitfähigkeit der elektrisch leitfähigen Strukturen und Kontaktpads unter Störung erhalten. Besonders bevorzugt weist der flexible Schaltungsträger Schlitzungen zur Erhöhung der Flexibilität auf, wobei sich die Schlitzungen von einem Rand des Trägers erstrecken und den Träger durchdringen, das heißt sich von der ersten Hauptoberfläche zu der zweiten Hauptoberfläche des Trägers durch den Träger hindurch erstrecken.

In einer bevorzugten Ausführungsform der Erfindung weist der erste beziehungsweise zweite Kontaktleiter eine Form auf, die an die Einbaulage des Trägers, insbesondere eines flexiblen Trägers, in einer implantierbaren elektronischen Bauelementanordnung angepasst ist. Mit anderen Worten weist der erste beziehungsweise zweite Kontaktleiter eine Form auf, die es auch bei Bauelementanordnungen mit komplexen Geometrien erlaubt, mittels des Verbindungselements elektrisch zu kontaktierende Bauelementen zu verbinden. Bauelementanordnungen mit komplexen, beispielsweise nicht planaren oder mehrfach gefalteten Geometrien werden verwendet, wenn nur ein sehr beschränkter Bauraum zur Verfügung steht, beispielsweise bei medizinischen Implantaten. Die komplexe Geometrie der Bauelementanordnung geht häufig mit einer komplexen, nicht-planaren Geometrie des Trägers einher. Aufgrund der Anpassung der Kontaktleiter an die Einbaulage des Trägers kann ein automatisiertes Schweißverfahren zum elektrischen Kontaktieren von Bauelementen durchgeführt werden, ohne dass beim Überführen des Trägers in seine Einbaulage mechanische Spannungen die Schweißstellen belasten. Die Anpassung der Form der Kontaktleiter an die Einbaulage des Trägers verbessert somit die Schweißmöglichkeit und die Schweißsicherheit der Kontaktleiter. Einmal verformte Kontaktleiter sind dabei ohne äußere Einflüsse unterhalb einer bestimmten Mindestverformungskraft formstabil, wobei die Mindestverformungskraft so gewählt ist, dass ungewollte Verformungen vermieden werden.

In einer bevorzugten Ausführungsform der Erfindung schließen der erste Abschnitt der ersten Oberfläche des ersten Kontaktleiters und der zweite Abschnitt der ersten Oberfläche des ersten Kontaktleiters einen Winkel, insbesondere einen Winkel ungleich 180°, das heißt einen spitzen, stumpfen oder rechten Winkel ein. Ebenfalls bevorzugt schließen der erste Abschnitt der ersten Oberfläche des zweiten Kontaktleiters und der zweite Abschnitt der ersten Oberfläche des zweiten Kontaktleiters einen spitzen, stumpfen oder rechten Winkel ein. Diese Ausgestaltungen ermöglichen eine Relativanordnung von dem ersten beziehungsweise zweiten Kontaktleiter und dem Träger, wobei der erste beziehungsweise zweite Kontaktleiter eine verbesserte Schweißmöglichkeit im zweiten Abschnitt aufweist. Das Verwenden gebogener oder geknickter Kontaktleiter ermöglicht zudem die Anpassung der Kontaktleiter an die Einbaulage des Trägers und die Verwendung des Verbindungselements bei Bauelementanordnung komplexer Geometrie.

In einer ebenfalls bevorzugten Ausführungsform weist die erste Oberfläche des ersten Kontaktleiters in deren ersten Abschnitt eine Beschichtung zur Verbesserung der Benetzbarkeit mit einem Lotmaterial auf. Ebenfalls bevorzugt weist die erste Oberfläche des zweiten Kontaktleiters in deren ersten Abschnitt eine Beschichtung zur Verbesserung der Benetzbarkeit mit einem Lotmaterial auf. Diese Beschichtungen erleichtern das Ausbilden einer Lotschicht zwischen dem ersten beziehungsweise zweitem Kontaktleiter und dem ersten beziehungsweise zweitem Kontaktpad. Aus der Mikroelektronik sind verschiedene Beschichtungen zur Verbesserung der Benetzbarkeit einer Metalloberfläche mit einem Lotmaterial bekannt. Die Eignung einer Beschichtung kann von dem jeweiligen Material eines Kontaktleiters beziehungsweise eines Kontaktpads variieren. Besonders bevorzugt weist eine Beschichtung zur Verbesserung der Benetzbarkeit mit dem Lotmaterial zumindest eines einer bleifreien Heißluftverzinnung (HAL), einer chemisch Nickel-Gold-Schicht (ENIG), einer chemisch Silber-Schicht (ImAG), einer verbleiten Verzinnung, einer galvanisch aufgetragenen Nickel-Gold-Schicht (galvanisch NiAu) und einer Beschichtung mit leitfähigem Kohlenstoff (Karbon) auf In einer besonders bevorzugten Ausführungsform weist die erste Oberfläche des ersten Abschnitts des ersten beziehungsweise zweiten Kontaktleiters eine ENIG Beschichtung auf

Ebenfalls Gegenstand der Erfindung ist eine elektronische Bauelementanordnung mit einem Verbindungselement für eine elektronische Bauelementanordnung, aufweisend einen Träger mit einer ersten Hauptoberfläche und einer der ersten Hauptoberfläche gegenüberliegenden zweiten Hauptoberfläche, ein auf einer der Hauptoberflächen des Trägers angeordnetes erstes Kontaktpad und ein auf einer der Hauptoberflächen des Trägers angeordnetes zweites Kontaktpad, eine das erste Kontaktpad und das zweite Kontaktpad elektrisch leitend miteinander verbindende elektrisch leitfähige Struktur und einen ersten Kontaktleiter mit einer ersten Oberfläche und einer der ersten Oberfläche gegenüberliegenden zweiten Oberfläche, wobei ein erster Abschnitt der ersten Oberfläche des ersten Kontaktleiters mittels einer Lotschicht mit dem ersten Kontaktpad elektrisch leitend verbunden ist und wobei der erste Kontaktleiter in einem zweiten Abschnitt der ersten Oberfläche und/oder auf der zweiten Oberfläche zum Ausbilden einer Schweißverbindung ausgestaltet ist, und mit einem elektronischen Bauelement mit einer mit dem zweiten Abschnitt der ersten Oberfläche des ersten Kontaktleiters oder mit der zweiten Oberfläche des ersten Kontaktleiters verschweißten Kontaktstelle. Das Verbindungselement ist somit wie vorstehend beschrieben und das elektronische Bauelement weist eine Kontaktstelle auf, die mit dem zweiten Abschnitt der ersten Oberfläche des ersten Kontaktleiters oder mit der zweiten Oberfläche des ersten Kontaktleiters verschweißt ist. In einer bevorzugten Ausführungsform der Bauelementanordnung weist das Verbindungselement eine Vielzahl erster Kontaktpads und eine Vielzahl mit diesen verlöteter erster Kontaktleiter auf und weist das Bauelement eine Vielzahl mit den ersten Kontaktleitern verschweißter Kontaktstellen auf. In einer besonders bevorzugten Ausführungsform der elektronischen Bauelementanordnung handelt es sich bei dem elektronischen Bauelement um einen implantierbaren Defibrillator oder einen implantierbaren Herzschrittmacher oder um ein Bauteil davon.

In einer bevorzugten Ausführungsform weist die elektronische Bauelementanordnung ein Verbindungselement auf, das zusätzlich einen zweiten Kontaktleiter mit einer ersten Oberfläche und einer der ersten Oberfläche gegenüberliegenden zweiten Oberfläche aufweist, wobei ein erster Abschnitt der ersten Oberfläche des zweiten Kontaktleiters über eine Lotschicht mit dem zweiten Kontaktpad elektrisch leitend verbunden ist und wobei der zweite Kontaktleiter in einem zweiten Abschnitt der ersten Oberfläche und/oder auf der zweiten Oberfläche zum Ausbilden einer Schweißverbindung ausgestaltet ist. In dieser Ausführungsform weist die elektronische Bauelementanordnung ferner eine Strom- oder Spannungsquelle mit einem Kontaktpin auf, wobei der Kontaktpin mit dem zweiten Abschnitt der ersten Oberfläche des zweiten Kontaktleiters oder mit der zweiten Oberfläche des zweiten Kontaktleiters verschweißt ist.

In einer alternativ bevorzugten Ausführungsform der elektronischen Bauelementanordnung weist das Verbindungselement einen zweiten Kontaktleiter mit einem Sackloch auf, das zum Aufnehmen eines Kontaktpins der Strom- oder Spannungsquelle ausgebildet ist. Das Sackloch ist bevorzugt in dem zweiten Abschnitt der ersten Oberfläche des zweiten Kontaktleiters oder in der zweiten Oberfläche des zweiten Kontaktleiters zusätzlich oder alternativ zu einem dort angeordneten Durchgangsloch angeordnet. Mittels des Sacklochs kann alternativ oder zusätzlich zu der Schweißverbindung eine Steckverbindung zwischen dem zweitem Kontaktleiter des Verbindungselements und dem Kontaktpin der Strom- oder Spannungsquelle hergestellt werden. Ebenfalls bevorzugt ist der zweite Kontaktleiter als Metallquader, besonders bevorzugt als Nickelquader ausgebildet. In einer weiteren alternativen Ausführungsform ist der Kontaktpin der Strom- oder Spannungsquelle über eine Lötverbindung mit dem zweiten Abschnitt der ersten Oberfläche des zweiten Kontaktleiters oder der zweiten Oberfläche des zweiten Kontaktleiters angeordnet.

In einer weiteren Ausführungsform der elektronischen Bauelementanordnung weist das Verbindungselement eine Mehrzahl auf dem Träger angeordneter dritter Kontaktpads auf, wobei jeweils zwei der dritten Kontaktpads über zumindest eine elektrisch leitfähige Struktur elektrisch leitend miteinander verbunden sind, und weist das Verbindungselement eine Mehrzahl auf dem Träger des Verbindungselements angeordneter dritter Kontaktleiter auf, die eine erste Oberfläche und eine der ersten Oberfläche gegenüberliegende zweite Oberfläche aufweisen, wobei jede erste Oberfläche eines dritten Kontaktleiters in einem ersten Abschnitt mittels eine Lotschicht elektrisch leitend mit einem dritten Kontaktpad verbunden ist.

Ebenfalls Gegenstand der Erfindung ist ein Verfahren zum Herstellen eines Verbindungselements für eine elektronische Bauelementanordnung mit den Verfahrensschritten: Bereitstellen eines Trägers mit einer ersten Hauptoberfläche und einer der ersten Hauptoberfläche gegenüberliegenden zweiten Hauptoberfläche, mit einem auf einer der Hauptoberflächen des Trägers angeordneten ersten Kontaktpad und einem auf einer der Hauptoberflächen des Trägers angeordneten zweiten Kontaktpad und mit einer das erste Kontaktpad und das zweite Kontaktpad elektrisch leitend miteinander verbindenden elektrisch leitfähigen Struktur; Bereitstellen eines ersten Kontaktleiters mit einer ersten Oberfläche und einer der ersten Oberfläche gegenüberliegenden zweiten Oberfläche, der in einem zweiten Abschnitt der ersten Oberfläche und/oder auf der zweiten Oberfläche zum Ausbilden einer Schweißverbindung ausgestaltet ist; Bestücken des Trägers mit dem ersten Kontaktleiter und dabei Anordnen des ersten Kontaktleiters auf dem Träger mit einem ersten Abschnitt des ersten Kontaktleiters über dem ersten Kontaktpad; und Verlöten des ersten Kontaktleiters durch Ausbilden einer Lotschicht zwischen dem ersten Abschnitt der ersten Oberfläche des ersten Kontaktleiters und dem ersten Kontaktpad zum elektrisch leitenden Verbinden von dem ersten Kontaktleiter und dem ersten Kontaktpad.

Das Verfahren dieser Durchführungsform ermöglicht das Herstellen eines schweißbaren Verbindungselements für eine elektronische Bauelementanordnung durch Bestücken eines Schaltungsträgers, bevorzugt eines flexiblen Schaltungsträgers wie obenstehend beschrieben, mit abschnittsweise schweißbaren Kontaktleitern und einseitiges Verlöten der Kontaktleiter mit Kontaktpads des Trägers. Es können kommerziell erhältliche flexible Substrate, wie beispielsweise FR4, Flex Substrate, LCP, PEEK, Thinfilm Technology, verwendet werden und bevorzugt erfolgt das Bestücken des Trägers in einem automatisierten SMT - Verfahren (*SMT - Surface Mount Technology*)*.* Ebenfalls bevorzugt erfolgt das Verlöten der Kontaktleiter in einem automatisierten Reflow-Lötverfahren. Das Verbindungselement gemäß der Erfindung ist somit in einem vollständig automatisierten Prozess herstellbar. Wird ein flexibler Schaltungsträger mit den schweißbaren Kontaktleitern bestückt, ist deren Anordnung an die spätere Einbaulage des Schaltungsträgers angepasst.

In einer bevorzugten Durchführungsform des Verfahrens zum Herstellen eines Verbindungselements erfolgt das Bestücken des Trägers mit dem ersten Kontaktleiter derart, dass der erste Abschnitt des ersten Kontaktleiters über dem ersten Kontaktpad angeordnet wird und in dem ersten Abschnitt die erste Oberfläche des ersten Kontaktleiters dem ersten Kontaktpad zugewandt ist. Vor oder nach dem Verlöten des ersten Kontaktleiters mit dem ersten Kontaktpad erfolgt ein Umformen, insbesondere ein Biegen, des ersten Kontaktleiters, so dass der zweite Abschnitt der ersten Oberfläche des ersten Kontaktleiters dem ersten Kontaktpad nicht zugewandt ist, beispielsweise in dem dieser mit dem ersten Abschnitt der ersten Oberfläche oder mit dem ersten Kontaktpad einen rechten Winkel einschließt. Ebenfalls bevorzugt erfolgt vor oder nach dem Verlöten des ersten Kontaktleiters mit dem ersten Kontaktpad zusätzlich ein Umformen, insbesondere Biegen, des ersten Kontaktleiters, so dass der zweite Abschnitt der ersten Oberfläche des ersten Kontaktleiters einer Hauptoberfläche des Trägers nicht zugewandt ist, beispielsweise in dem dieser mit dem ersten Abschnitt der ersten Oberfläche oder mit dem Träger einen rechten Winkel einschließt. Alternativ zum Biegen der Kontaktleiter kann deren Umformung beispielsweise auch mittels Stanzen erfolgen.

In einer ebenfalls bevorzugten Durchführungsform des Verfahrens zum Herstellen eines Verbindungselements erfolgt ein Bestücken des Trägers mit dem ersten Kontaktleiter derart, dass der erste Abschnitt des ersten Kontaktleiters über dem ersten Kontaktpad angeordnet, in dem ersten Abschnitt die erste Oberfläche des ersten Kontaktleiters dem ersten Kontaktpad zugewandt ist und der zweite Abschnitt der ersten Oberfläche des ersten Kontaktleiters nicht über einer Hauptoberfläche des Trägers angeordnet ist, beispielsweise indem dieser über einen Rand des Trägers übersteht. Dabei kann der zweite Abschnitt des ersten Kontaktleiters über einen seitlichen Rand des Trägers oder über den Rand einer Öffnung im Träger überstehen. Mit diesem Verfahren wird ein Verbindungselement mit erhöhter Schweißmöglichkeit hergestellt.

In einer weiteren Durchführungsform des Verfahrens zum Herstellen eines Verbindungselements wird ein erster Kontaktleiter aus Nickel, Kupfer, Tantal, Niob, Aluminium oder Legierungen davon bereitgestellt und in einem ersten Abschnitt der ersten Oberfläche mit einer Beschichtung zur Verbesserung der Benetzbarkeit mit einem Lotmaterial beschichtet und anschließend ein Lotmaterial auf den beschichteten ersten Abschnitt der ersten Oberfläche des ersten Kontaktleiters aufgebracht, um eine Lotschicht auszubilden. Alternativ wird ein erster Kontaktleiter aus einem anderen Material bereitgestellt, der in einem zweiten Abschnitt der ersten Oberfläche oder auf der zweiten Oberfläche mit Nickel, Kupfer, Tantal, Niob, Aluminium oder Legierungen davon beschichtet ist. Besonders bevorzugt wird auf den ersten Abschnitt der ersten Oberfläche des ersten Kontaktleiters eine HAL-Beschichtung durch Tauchen des ersten Kontaktleiters, eine ENIG-Schicht oder eine ImAg-Schicht in einem autokatalytischen Prozess, eine NiAu-Schicht galvanisch aufgetragen oder eine Beschichtung mit leitfähigem Kohlenstoff aufgewachsen. Gleiches gilt für einen zweiten oder dritten Kontaktleiter. In einer besonders bevorzugten Ausführungsform wird die erste Oberfläche des ersten Abschnitts des ersten beziehungsweise zweiten Kontaktleiters mit ENIG beschichtet.

Ebenfalls Gegenstand der Erfindung ist ein Verfahren zum Herstellen einer elektronischen Bauelementanordnung, aufweisend die Verfahrensschritte: Bereitstellen eines Trägers mit einer ersten Hauptoberfläche und einer der ersten Hauptoberfläche gegenüberliegenden zweiten Hauptoberfläche, mit einem auf einer der Hauptoberflächen des Trägers angeordneten ersten Kontaktpad und einem auf einer der Hauptoberflächen des Trägers angeordneten zweiten Kontaktpad und mit einer das erste Kontaktpad und das zweite Kontaktpad elektrisch leitend miteinander verbindenden elektrisch leitfähigen Struktur; Bereitstellen eines ersten Kontaktleiters mit einer ersten Oberfläche und einer der ersten Oberfläche gegenüberliegenden zweiten Oberfläche, der in einem zweiten Abschnitt der ersten Oberfläche und/oder auf der zweiten Oberfläche zum Ausbilden einer Schweißverbindung ausgestaltet ist; Bestücken des Trägers mit dem ersten Kontaktleiter und dabei Anordnen des ersten Kontaktleiters auf dem Träger mit einem ersten Abschnitt des ersten Kontaktleiters über dem ersten Kontaktpad; Verlöten des ersten Kontaktleiters durch Ausbilden einer Lotschicht zwischen dem ersten Abschnitt der ersten Oberfläche des ersten Kontaktleiters und dem ersten Kontakt zum elektrisch leitenden Verbinden von erstem Kontaktleiter und erstem Kontaktpad; Bereitstellen eines elektronischen Bauelements mit einer Kontaktstelle, die zum Ausbilden einer Schweißverbindung ausgestaltet ist; und Verschweißen des zweiten Abschnitts der ersten Oberfläche des ersten Kontaktleiters oder der zweiten Oberfläche des ersten Kontaktleiters mit der Kontaktstelle des elektronischen Bauelements.

Bevorzugt weist das Verfahren zum Herstellen einer elektronischen Bauelementanordnung ferner die Verfahrensschritte auf: Bereitstellen eines zweiten Kontaktleiters mit einer ersten Oberfläche und einer der ersten Oberfläche gegenüberliegenden zweiten Oberfläche, der in einem zweiten Abschnitt der ersten Oberfläche und/oder auf der zweiten Oberfläche zum Ausbilden einer Schweißverbindung ausgestaltet ist; Bestücken des Trägers mit dem zweiten Kontaktleiter und dabei Anordnen des zweiten Kontaktleiters auf dem Träger mit einem ersten Abschnitt des zweiten Kontaktleiters über dem zweiten Kontaktpad; Verlöten des zweiten Kontaktleiters durch Ausbilden einer Lotschicht zwischen dem ersten Abschnitt der ersten Oberfläche des zweiten Kontaktleiters und dem zweiten Kontaktpad zum elektrisch leitenden Verbinden von zweitem Kontaktleiter und zweitem Kontaktpad; Bereitstellen einer Strom- oder Spannungsquelle mit einem Kontaktpin, der zum Ausbilden einer Schweißverbindung, Lötverbindung oder Steckverbindung ausgestaltet ist; und Verbinden des zweiten Abschnitts der ersten Oberfläche des zweiten Kontaktleiters oder der zweiten Oberfläche des zweiten Kontaktleiters mit dem Kontaktpin der Strom- oder Spannungsquelle zum Herstellen einer elektrisch leitfähigen Verbindung zwischen Kontaktpin und zweitem Kontaktleiter. In einer bevorzugten Durchführungsform ist der Kontaktpin der Strom- oder Spannungsquelle zum Ausbilden einer Schweißverbindung ausgebildet und erfolgt das Verbinden des zweiten Abschnitts der ersten Oberfläche des zweiten Kontaktleiters oder der zweiten Oberfläche des zweiten Kontaktleiters mit dem Kontaktpin der Strom- oder Spannungsquelle durch ein Verschweißen, besonders bevorzugt Laserverschweißen, des zweiten Abschnitts der ersten Oberfläche des zweiten Kontaktleiters oder der zweiten Oberfläche des zweiten Kontaktleiters mit dem Kontaktpin der Strom- oder Spannungsquelle.

Das Verfahren zum Herstellen einer elektronischen Bauelementanordnung gemäß der Erfindung ermöglicht vorteilhaft die vollständig automatisierte Fertigung einer Bauelementanordnung, insbesondere eines implantierbaren elektronischen Geräts wie eines Defibrillators oder Herzschrittmachers, angefangen vom automatisierten Bestücken und Verlöten eines Trägers, bevorzugt eines flexiblen Substrats, mit den Kontaktleitern bis zum vollständig automatisierten Verschweißen des Verbindungselements mit einem Bauelement und einer Strom- oder Spannungsquelle. Dabei können standardisierte und an die zu verschweißenden Komponenten angepasste Kontaktleiter eingesetzt werden, auch bei der Nutzung verschiedener Trägermaterialen.

In einer ebenfalls bevorzugten Durchführungsform des Verfahrens zum Herstellen einer elektronischen Bauelementanordnung sind eine Mehrzahl dritter Kontaktpads auf einer oder mehreren der Hauptoberflächen des bereitgestellten Trägers angeordnet und über zumindest eine elektrisch leitfähige Struktur elektrisch leitend miteinander verbunden. Der Träger wird ferner mit einer Mehrzahl dritter Kontaktleiter bestückt, die jeweils eine erste Oberfläche und eine der ersten Oberfläche gegenüberliegende zweite Oberfläche aufweisen, wobei jeder dritte Kontaktleiter mit einem ersten Abschnitt seiner ersten Oberfläche über einem dritten Kontaktpad auf dem Träger angeordnet wird. Jeder erste Abschnitt der ersten Oberfläche eines dritten Kontaktleiters wird durch Ausbilden einer Lotschicht mit einem dritten Kontaktpad verlötet und elektrisch leitend mit diesem verbunden.

In einer weiteren Durchführungsform weist das Verfahren zum Herstellen einer elektronischen Bauelementanordnung ferner die Verfahrensschritte auf: Bestücken des Trägers mit dem ersten Kontaktleiter und dabei Anordnen des ersten Kontaktleiters auf dem Träger, so dass der erste Abschnitt des ersten Kontaktleiters über dem ersten Kontaktpad angeordnet und in dem ersten Abschnitt die erste Oberfläche des ersten Kontaktleiters dem ersten Kontaktpad zugewandt ist; und Umformen, insbesondere Biegen, des ersten Kontaktleiters, so dass der zweite Abschnitt der ersten Oberfläche des ersten Kontaktleiters dem ersten Kontaktpad nicht zugewandt ist. Das Umformen des Kontaktleiters kann dabei vor oder nach dem Bestücken des Trägers mit denselben erfolgen. Mit anderen Worten kann der Träger mit bereits umgeformten, insbesondere gebogenen oder geknickten, Kontaktleitern bestückt werden. Alternativ erfolgt die Umformung der Kontaktleiter mittels Stanzen.

In einer anderen Durchführungsform weist das Verfahren zum Herstellen einer elektronischen Bauelementanordnung ferner die Verfahrensschritte auf: Bestücken des Trägers mit dem ersten Kontaktleiter und dabei Anordnen des ersten Kontaktleiters auf dem Träger, so dass der erste Abschnitt des ersten Kontaktleiters über dem ersten Kontaktpad angeordnet und in dem ersten Abschnitt die erste Oberfläche des ersten Kontaktleiters dem ersten Kontaktpad zugewandt ist und so dass der zweite Abschnitt der ersten Oberfläche des ersten Kontaktleiters nicht über einer Hauptoberfläche des Trägers angeordnet ist. Dabei kann der zweite Abschnitt des ersten Kontaktleiters beispielsweise seitlich über den Träger überstehen, wobei er über einen seitlichen Rand des Trägers oder über den Rand einer Öffnung im Träger überstehen kann.

Bevorzugt weist das Verfahren zum Herstellen einer elektronischen Bauelementanordnung in einer Durchführungsform die Verfahrensschritte auf: Bereitstellen eines ersten Kontaktleiters aus Nickel, Kupfer, Tantal, Niob, Aluminium oder Legierungen davon; Beschichten eines ersten Abschnitts der ersten Oberfläche des ersten Kontaktleiters mit einer Beschichtung zur Verbesserung der Benetzbarkeit mit einem Lotmaterial; und Aufbringen eines Lotmaterials auf den ersten Abschnitt der ersten Oberfläche des ersten Kontaktleiters zum Ausbilden der Lotschicht zwischen erstem Kontaktleiter und erstem Kontaktpad. Ebenfalls bevorzugt weist das Verfahren zum Herstellen einer elektronischen Bauelementanordnung in einer Durchführungsform die Verfahrensschritte auf: Bereitstellen eines zweiten und/oder dritten Kontaktleiters aus Nickel, Kupfer, Tantal, Niob, Aluminium oder Legierungen davon; Beschichten eines ersten Abschnitts der ersten Oberfläche des zweiten und/oder dritten Kontaktleiters mit einer Beschichtung zur Verbesserung der Benetzbarkeit mit einem Lotmaterial; und Aufbringen eines Lotmaterials auf den ersten Abschnitt der ersten Oberfläche des zweiten und/oder Kontaktleiters zum Ausbilden der Lotschicht zwischen zweitem beziehungsweise drittem Kontaktleiter und zweitem beziehungsweise drittem Kontaktpad. Mit diesen Durchführungsformen des Verfahrens lassen sich besonders hochwertige Schweißverbindungen erzeugen. Alternativ wird ein erster Kontaktleiter aus einem anderen Material bereitgestellt, der in einem zweiten Abschnitt der ersten Oberfläche oder auf der zweiten Oberfläche mit Nickel, Kupfer, Tantal, Niob, Aluminium oder Legierungen davon beschichtet ist. Besonders bevorzugt wird auf den ersten Abschnitt der ersten Oberfläche eines Kontaktleiters eine HAL-Beschichtung durch Tauchen des Kontaktleiters, eine ENIG-Schicht oder eine ImAg-Schicht in einem autokatalytischen Prozess, eine NiAu-Schicht galvanisch aufgetragen oder eine Beschichtung mit leitfähigem Kohlenstoff aufgewachsen. In einer besonders bevorzugten Ausführungsform wird die erste Oberfläche des ersten Abschnitts eines Kontaktleiters mit ENIG beschichtet.

In einer ebenfalls bevorzugten Durchführungsform weist das Verfahren zum Herstellen einer elektronischen Bauelementanordnung ferner die Verfahrensschritte auf: Bereitstellen eines ersten Kontaktleiters mit einer in dessen zweiten Abschnitt angeordneten Durchgangsöffnung von der ersten Oberfläche zu der zweiten Oberfläche des ersten Kontaktleiters und Laserverschweißen des zweiten Abschnitts der ersten Oberfläche des ersten Kontaktleiters oder der zweiten Oberfläche des ersten Kontaktleiters mit der Kontaktstelle des elektronischen Bauelements durch die Durchgangsöffnung hindurch. Ebenfalls bevorzugt weist das Verfahren zum Herstellen einer elektronischen Bauelementanordnung ferner die Verfahrensschritte auf: Bereitstellen eines zweiten und/oder dritten Kontaktleiters mit einer in dessen zweiten Abschnitt angeordneten Durchgangsöffnung von der ersten Oberfläche zu der zweiten Oberfläche des zweiten und/oder dritten Kontaktleiters und Laserverschweißen des zweiten Abschnitts der ersten Oberfläche des zweiten und/oder dritten Kontaktleiters oder der zweiten Oberfläche des zweiten und/oder dritten Kontaktleiters mit dem Kontaktpin der Strom- oder Spannungsquelle, wobei das Laserverschweißen durch die Durchgangsöffnung hindurch erfolgt. Ebenfalls bevorzugt wird die Durchgangsöffnung als Positionsmarke zum Ausrichten des Laserstrahls in einem automatisierten Schweißverfahren genutzt. Ebenfalls bevorzugt wird die mittels Laserverschweißen erzeugte Schweißverbindung mit einer optischen Prüfvorrichtung durch die Durchgangsöffnung hindurch optisch geprüft. Die optische Prüfung kann dabei ebenfalls automatisiert erfolgen (AOI - automated optical inspection).

Ebenfalls Gegenstand der Erfindung ist die Verwendung eines Verbindungselements für eine elektronische Bauelementanordnung gemäß einer Ausführungsform der Erfindung in einem implantierbaren elektronischen Gerät, insbesondere in einem Defibrillator oder einem Herzschrittmacher. Ebenfalls Gegenstand der Erfindung ist die Verwendung einer elektronischen Bauelementanordnung gemäß einer Ausführungsform der Erfindung in einem implantierbaren elektronischen Gerät, insbesondere einem Defibrillator oder einem Herzschrittmacher. Ebenfalls Gegenstand der Erfindung ist ein Medizinisches Implantat, aufweisend ein biokompatibles Gehäuse, das eine Bauelementanordnung gemäß einer Ausführungsform der Erfindung flüssigkeitsdicht umschließt.

Im Folgenden wird die Erfindung anhand einiger Ausführungsbeispiele und Figuren erläutert, ohne auf diese beschränkt zu sein. Dabei zeigen:
- Fig. 1: eine perspektivische Darstellung eines Verdrahtungsbands gemäß einem Ausführungsbeispiel;
- Fig. 2: eine Draufsicht auf ein Verbindungselement für eine elektronische Bauelementanordnung gemäß einer Ausführungsform der Erfindung;
- Fig. 3: eine detaillierte Draufsicht auf einen Träger eines Verbindungselements für eine elektronische Bauelementanordnung gemäß einer Ausführungsform der Erfindung;
- Fig. 4: eine Vorder- und Rückansicht eines ersten Kontaktleiters eines Verbindungselements für eine elektronische Bauelementanordnung gemäß einer Ausführungsform der Erfindung;
- Fig. 5: eine Vorder- und Rückansicht eines zweiten Kontaktleiters eines Verbindungselements für eine elektronische Bauelementanordnung gemäß einer Ausführungsform der Erfindung;
- Fig. 6: eine schematische Darstellung eines Verfahrens zum Herstellen eines Verbindungselements für eine elektronische Bauelementanordnung gemäß einer Durchführungsform der Erfindung;
- Fig. 7: eine schematische Darstellung eines Verfahrens zum Herstellen einer elektronischen Bauelementanordnung gemäß einer Durchführungsform der Erfindung; und
- Fig. 8: eine Rückansicht einer weiteren Ausführungsform des Verbindungselements für eine elektronische Bauelementanordnung gemäß der Erfindung.

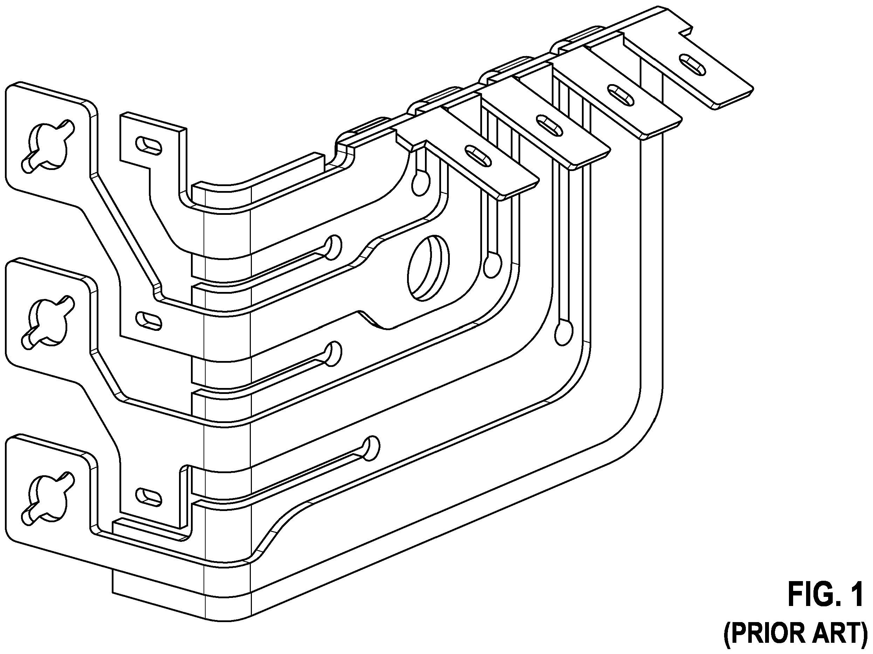

Figur 1 zeigt ein Ausführungsbeispiel eines Verdrahtungsbandes, wie es bislang zum elektrisch leitfähigen Verbinden der Bauelemente einer implantierbaren elektronischen Bauelementanordnung, beispielsweise eines Herzschrittmachers oder Defibrillators, genutzt wird. Das dargestellte Verdrahtungsband besteht aus geätzten metallischen Leitern, die beidseitig mit einer Isolierfolie aus Polyimid laminiert sind. Zwischen den metallischen Leitern müssen Mindestabstände von 0,6 mm eingehalten werden, damit die Isolierfolien gut miteinander laminieren. Es können keine sich kreuzenden Leiterbahnen innerhalb eines Verdrahtungsbandes realisiert werden. Vor dem Verbinden der Bauelemente werden die Verdrahtungsbänder in Form gebogen. Durch die laminierte Polyimidfolie ergeben sich Rückstellkräfte, welche die metallischen Leiter zum "Auffedern" bewegen. Dies verringert die geometrische Genauigkeit des Verdrahtungsbandes und führt zu Passungenauigkeiten.

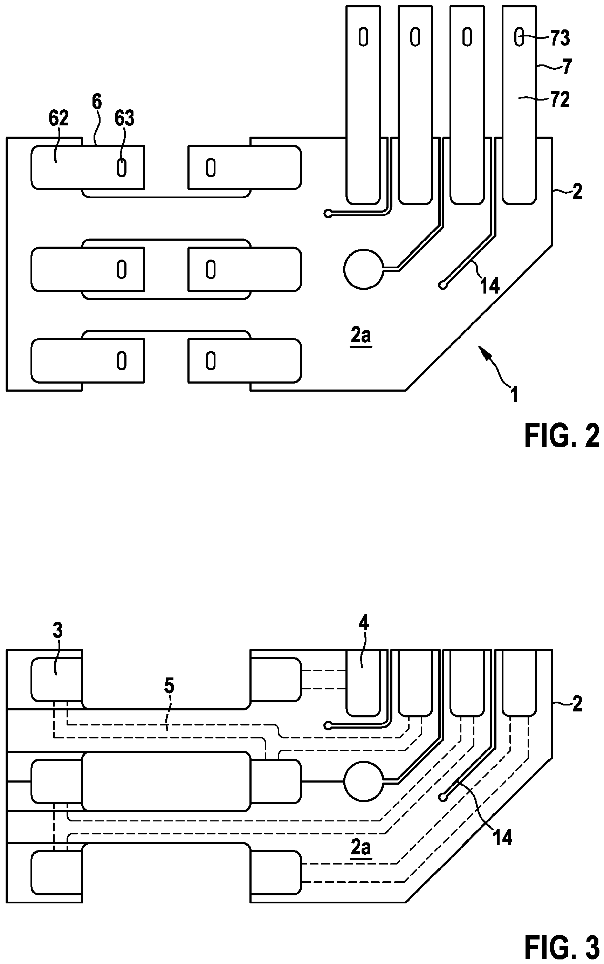

Figur 2 zeigt eine Draufsicht auf ein Verbindungselement 1 für eine elektronische Bauelementanordnung gemäß einer Ausführungsform der Erfindung. Das Verbindungselement weist einen Träger 2 aus Flex Substrat auf. Eine detaillierte Draufsicht auf diesen Träger ist in Figur 3 dargestellt.

Der Träger 2 weist eine erste flexible dielektrische Hauptoberfläche 2a und eine gegenüberliegende flexible dielektrische Hauptoberfläche 2b auf, zwischen denen eine flexible strukturierte Kupfermetallisierung mit einer Dicke zwischen 20 µm und 50 µm elektrisch leitfähige Strukturen 5 bildet. Auf der ersten Hauptoberfläche 2a des Trägers 2 sind sechs erste Kontaktpads 3 angeordnet. Die ersten Kontaktpads 3 bestehen aus goldbeschichteten Metallisierungen, welche die erste Hauptoberfläche 2a des Trägers 2 durchdringen und die Kupfermetallisierungen 5 elektrisch über Durchkontaktierungen (sogenannte Vias) kontaktieren. Vier der ersten Kontaktpads 3 sind an einem Außenrand des Trägers 2 angeordnet und zwei der ersten Kontaktpads 3 sind am Rand einer Öffnung im Träger 2 angeordnet. Wie in Figur 2 dargestellt, sind sechs erste Kontaktleiter 6 mit den ersten Kontaktpads 3 verlötet, so dass ein Teil der ersten Kontaktleiter 6 über den Rand des Trägers 2 übersteht.

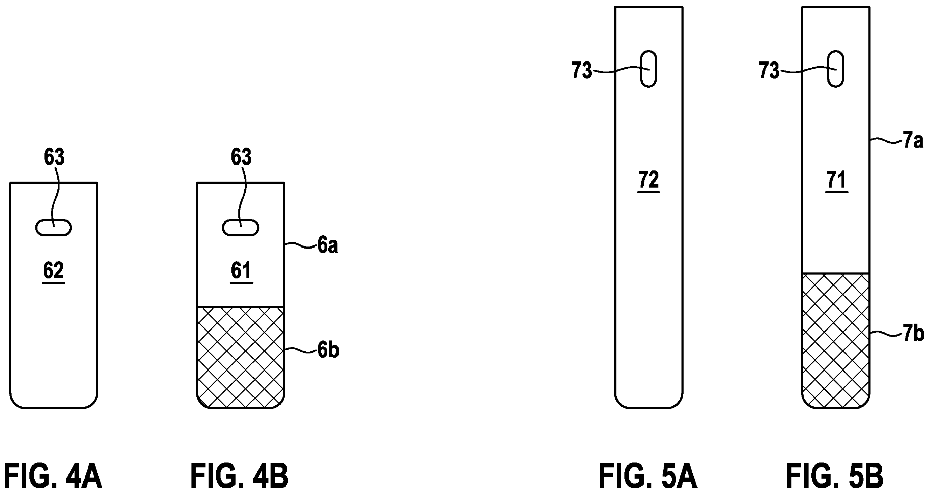

Eine Vorder- und Rückansicht eines ersten Kontaktleiters 6 sind in Figur 4 gezeigt. Dabei zeigt Figur 4A die Rückseite als zweite Oberfläche 62 des ersten Kontaktleiters 6 und zeigt Figur 4B die Vorderseite als erste Oberfläche 61 des ersten Kontaktleiters 6. Der erste Kontaktleiter 6 ist aus Nickelband aus 99% reinem Nickel (ASTM B-162) gebildet und weist eine Dicke von etwa 0,1 mm auf. Die Breite des ersten Kontaktleiters 6 beträgt in etwa 1,2 mm und entspricht im Wesentlichen der Breite der ersten Kontaktpads 3. Die Länge eines ersten Kontaktleiters beträgt in etwa 3,4 mm und ist so gewählt, das ein an ein erstes Kontaktpad 3 gelöteter erster Kontaktleiter 6 über einen Rand des Trägers 2 übersteht. In einem ersten Abschnitt 6a der ersten Oberfläche 61 des ersten Kontaktleiters 6 ist eine ENIG Beschichtung 8 zur Verbesserung der Benetzbarkeit mit einem Lotmaterial aufgebracht. In einem zweiten Abschnitt 6b des ersten Kontaktleiters 6 ist eine Durchgangsöffnung 63 angeordnet, welche die Vorderseite 61 des ersten Kontaktleiters 6 mit dessen Rückseite 62 verbindet.

Wie in Figur 3 dargestellt, sind vier zweite Kontaktpads 4 an einem Außenrand der ersten Hauptoberfläche 2a des Trägers 2 angeordnet. Die zweiten Kontaktpads 4 bestehen ebenfalls aus goldbeschichteten Metallisierungen, welche die erste Hauptoberfläche 2a des Trägers 2 durchdringen und die Kupfermetallisierung 5 elektrisch kontaktieren. Die zweiten Kontaktpads 4 sind über die Kupfermetallisierungen 5 elektrisch leitend mit ersten Kontaktpads 3 verbunden. Wie in Figur 2 dargestellt, sind vier zweite Kontaktleiter 7 mit den vier zweiten Kontaktpads 4 verlötet und stehen teilweise über den Rand des Trägers 2 über.

Eine Vorder- und Rückansicht eines zweiten Kontaktleiters 7 sind in Figur 5 gezeigt. Dabei zeigt Figur 5A die Rückseite als zweite Oberfläche 72 des zweiten Kontaktleiters 7 und zeigt Figur 5B die Vorderseite als erste Oberfläche 71 des zweiten Kontaktleiters 7. Der zweite Kontaktleiter ist aus Nickelband aus 99% reinem Nickel (ASTM B-162) gebildet und weist eine Dicke von etwa 0,1 mm auf. Die Breite des zweiten Kontaktleiters 7 beträgt in etwa 0,9 mm und entspricht im Wesentlichen der Breite der zweiten Kontaktpads 4. Die Länge eines zweiten Kontaktleiters beträgt in etwa 6,2 mm und ist so gewählt, das ein an ein zweites Kontaktpad 4 gelöteter zweiter Kontaktleiter 7 über einen Rand des Trägers 2 übersteht. In einem ersten Abschnitt 7a der ersten Oberfläche 71 des zweiten Kontaktleiters 7 ist eine ENIG Beschichtung 8 zur Verbesserung der Benetzbarkeit mit einem Lotmaterial aufgebracht. In einem zweiten Abschnitt 7b des zweiten Kontaktleiters 7 ist eine Durchgangsöffnung 73 angeordnet, welche als Langloch 73 mit einer Länge von in etwa 0,5 mm ausgebildet ist und die Vorderseite 71 des zweiten Kontaktleiters 7 mit dessen Rückseite 72 verbindet.

Der in Figur 3 gezeigte Träger 2 weist ferner Schlitzungen 14 auf, welche sich von einem Rand des Trägers 2 erstrecken und diesen von der ersten Hauptoberfläche 2a zur gegenüberliegenden Hauptoberfläche 2b durchdringen. Die Schlitzungen 14 sind durch Laserschneiden des Trägers 2 erzeugt worden und weisen eine Breite von ca. 0,1 mm auf. Die Schlitzungen 14 sind jeweils zwischen den zweiten Kontaktpads 4 angeordnet, so dass der flexible Träger 2 im Bereich dieser Kontaktpads 4 eine erhöhte Flexibilität aufweist. Die Schlitzungen 14 ermöglichen dabei einen Versatz in der Fläche von +/- 1 mm und somit einen Toleranzausgleich mittels des Verbindungselements 1. Insbesondere können die zweiten Kontaktpads 4 sicher mit zueinander in der Höhe versetzten Kontaktpins einer zu verbindenden Strom- oder Spanungsquelle kontaktiert werden.

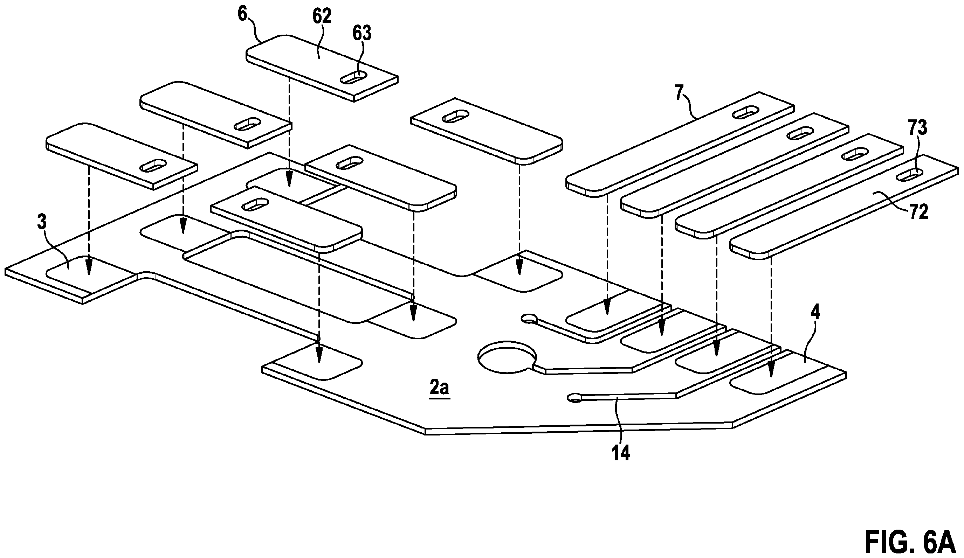

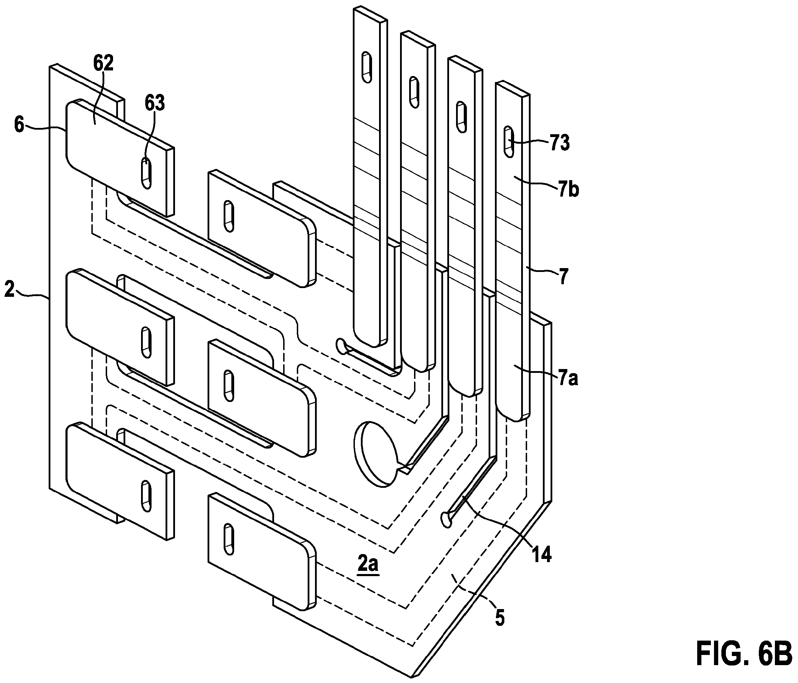

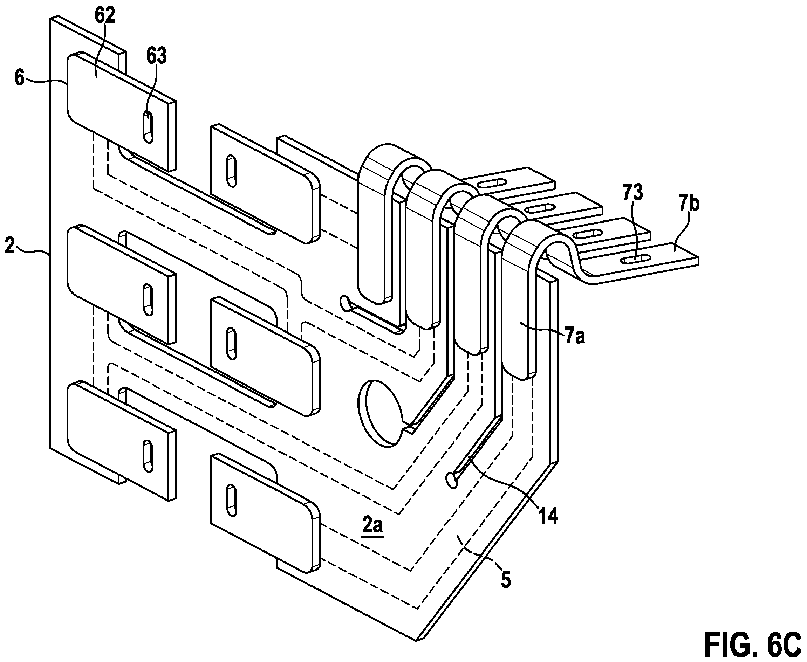

Eine schematische Darstellung eines Verfahrens zum Herstellen eines Verbindungselements 1 für eine elektronische Bauelementanordnung ist in Figur 6 gezeigt. Dabei zeigt Figur 6A erste Teilschritte des Verfahrens, in denen zunächst ein Träger 2, wie in Figur 2 dargestellt, bereitgestellt wird. Der Träger 2 wird dann mit sechs ersten Kontaktleitern 6, wie in Figur 3 dargestellt, bestückt. Diese werden so über dem Träger 2 angeordnet, dass ein erster, mit ENIG 8 beschichteter Abschnitt 6a der ersten Oberfläche 61 der ersten Kontaktleiter 6 jeweils über einem ersten Kontaktpad 3 angeordnet ist. Anschließend werden die ersten Kontaktleiter 6 automatisiert mittels Reflow-Löten unter Ausbildung einer Lotschicht 11 mit den ersten Kontaktpads 3 stoffschlüssig und elektrisch verbunden.

Zudem wird der Träger 2 automatisiert mit vier zweiten Kontaktleitern 7, wie in Figur 4 dargestellt, bestückt. Diese werden so über dem Träger 2 angeordnet, dass ein erster mit ENIG 8 beschichteter Abschnitt 7a der ersten Oberfläche 71 der zweiten Kontaktleiter 7 jeweils über einem zweiten Kontaktpad 4 angeordnet ist. Anschließend werden die zweiten Kontaktleiter 7 automatisiert mittels Reflow-Löten unter Ausbildung einer Lotschicht 11 mit den zweiten Kontaktpads 4 stoffschlüssig und elektrisch verbunden.

Durch das automatisierte Bestücken und Verlöten wird ein Verbindungselement 1, wie in Figur 6B gezeigt, erhalten. Bei diesem sind die ersten Kontaktleiter 6 so mit dem Träger 2 verlötet, dass jeweils zweite Abschnitte 6b der ebenen ersten Kontaktleiter 6 über einen Rand des Trägers 2 überstehen und jeweils ein Durchgangsloch 63 aufweisen. Der zweite Abschnitt 6b der ersten Kontaktleiter 6 ist somit nicht über dem Träger 2 angeordnet. Zudem sind die ebenen zweiten Kontaktleiter 7 so mit dem Träger 2 verlötet, dass jeweils zweite Abschnitte 7b der zweiten Kontaktleiter 7 über einen Rand des Trägers 2 überstehen und jeweils ein Durchgangsloch 73 aufweisen. Der zweite Abschnitt 7b der ersten Kontaktleiter 7 ist somit nicht über dem Träger 2 angeordnet.

In einem letzten Verfahrensschritt werden die zweiten Kontaktleiter 7 so umgeformt, dass die über den Außenrand des Trägers 2 überstehenden zweiten Abschnitte 7b der zweiten Kontaktleiter 7 gebogen werden. Dadurch wird ein Verbindungselement 1 erhalten, wie in Figur 6C gezeigt. Die zweiten Abschnitte 7b der zweiten Kontaktleiter 7 schließen dabei einen annähernd rechten Winkel mit den ersten Abschnitten 7a der zweiten Kontaktleiter 7 ein.

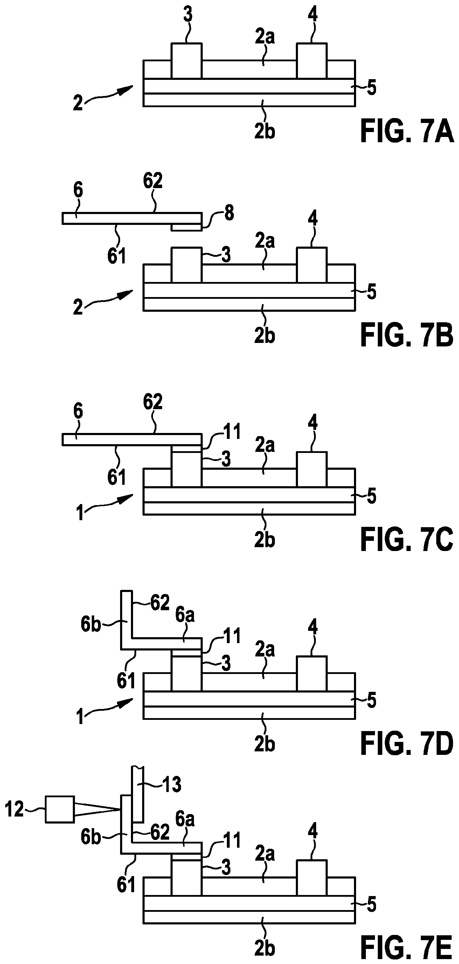

Eine schematische Darstellung eines Verfahrens zum Herstellen einer elektronischen Bauelementanordnung mit einem Verbindungselement 1, wie obenstehend beschrieben, ist in Figur 7 gezeigt. Dabei zeigt Figur 7A, wie ein Träger 2 mit einer ersten Hauptoberfläche 2a und einer gegenüberliegenden zweiten Hauptoberfläche 2b bereitgestellt wird. Der Träger 2 weist ferner eine zwischen den dielektrischen Hauptoberflächen 2a, 2b angeordnete Kupfermetallisierung 5 auf. Auf der ersten Hauptoberfläche 2a sind ein erstes Kontaktpad 3 und ein zweites Kontaktpad 4 angeordnet, welche die dielektrische Hauptoberfläche 2a durchdringen und die Kupfermetallisierung 5 elektrisch kontaktieren.

Figur 7B zeigt, wie ein erster Kontaktleiter 6, wie in Figur 3 dargestellt, so über dem Träger 2 angeordnet wird, dass ein erster Abschnitt 6a der ersten Oberfläche 61, in dem eine ENIG Beschichtung 8 aufgebracht ist, über dem ersten Kontaktpad 3 angeordnet ist. Die erste Oberfläche 61 des ersten Kontaktleiters 6 ist dabei dem ersten Kontaktpad 3 zugewandt. Figur 7C zeigt, wie der erste Kontaktleiter 6 automatisiert mittels Reflow-Löten über eine Lötschicht 11 elektrisch leitend mit dem ersten Kontaktpad 3 verbunden wird.

Anschließend wird der zweite Abschnitt 6b des ersten Kontaktleiters 6 mittels Biegen umgeformt, so dass er mit dem ersten Abschnitt 6a des ersten Kontaktleiters 6 einen rechten Winkel einschließt, wie in Figur 7D dargestellt.

In Figur 7E ist gezeigt, wie der erste Kontaktleiter 6 in einem Laserschweißverfahren elektrisch leitend mit einer Kontaktstelle 13 eines elektronischen Bauelements (nicht dargestellt) verbunden wird. Dazu wird die Kontaktstelle 13 im zweiten Abschnitt 6b des ersten Kontaktleiters 6 an dessen zweite Oberfläche 62 angelegt. Anschließend wird der Strahl eines Schweißlasers 12 auf den zweiten Abschnitt 6b des ersten Kontaktleiters 6 und gerichtet und trifft auf diese und, durch die Durchgangsöffnung 63 hindurch, auf die Kontaktstelle 13 des Bauelements auf. Dadurch wird der erste Kontaktleiter 6 im zweiten Abschnitt 6b oberflächlich aufgeschmolzen und geht eine Schweißverbindung mit der ebenfalls oberflächlich aufgeschmolzenen Kontaktstelle 13 ein.

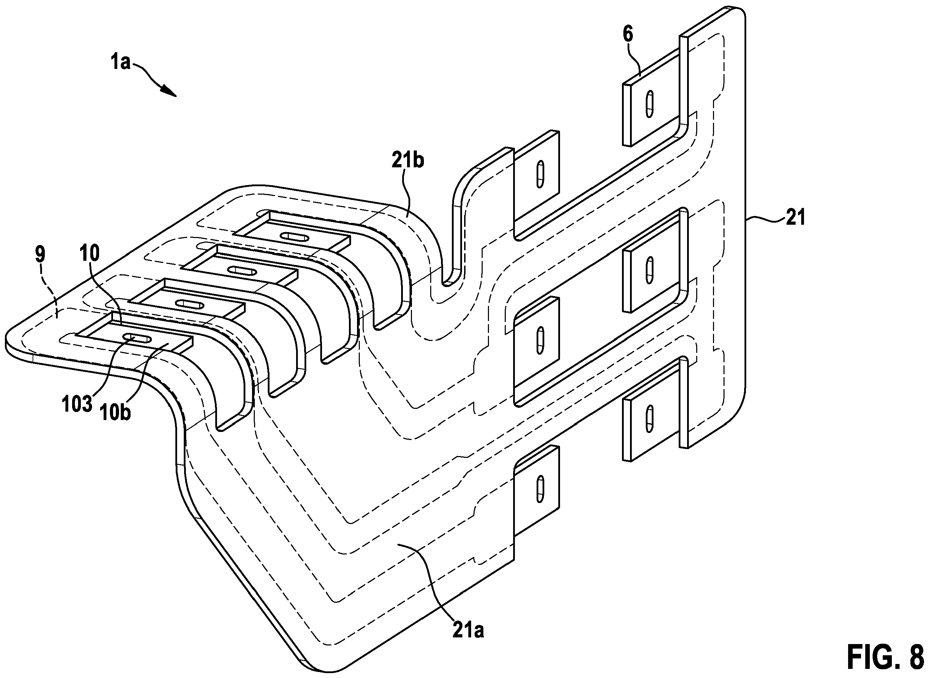

Figur 8 zeigt die Rückansicht einer weiteren Ausführungsform des Verbindungselements 1a für eine elektronische Bauelementanordnung gemäß der Erfindung. Verbindungselement 1a weist eine weitere Ausführungsform des Trägers 21 aus Flex Substrat auf sowie einen ersten Kontaktleiter 6, welcher mit Träger 21 verbunden ist wie in den vorherigen Figuren beschrieben. Des Weiteren weist Verbindungselement 1a einen dritten Kontaktleiter 10 auf, der in Analogie zum zweiten Kontaktleiter 7, eine erste und zweite Oberfläche (nicht dargestellt in Figur 8), einen ersten Abschnitt (nicht dargestellt in Figur 8) und zweiten Abschnitt 10b sowie eine Durchgangsöffnung 103 aufweist. Auch umfasst Träger 21 ein drittes Kontaktpad 9 (auf der Rückseite des Trägers 21 in Figur 8 befindlich), auf welches der dritte Kontaktleiter 10 gelötet ist. Diese Ausführungsform des Verbindungselements 1a ist dadurch gekennzeichnet, dass der dritte Kontaktleiter 10 für eine Orientierung zum Abschnitt 21a des Trägers 21 sowie zum Kontaktleiter 6 um einen Winkel von beispielsweise 90° nicht umgebogen werden muss, da der biegsame Teil durch einen Abschnitt 21b des Trägers gebildet wird. Das Biegen könnte bei der Montage des Verbindungselements 1a durchgeführt werden, sodass kein Biegewerkzeug für Verbindungselement 10 benötigt würde.

### Bezugszeichenliste

- 1: Verbindungselement
- 1a: Weitere Ausführungsform des Verbindungselements
- 2: Träger
- 2a: erste Hauptoberfläche des Trägers
- 2b: zweite Hauptoberfläche des Trägers
- 21: Weitere Ausführungsform des Trägers
- 21a: Abschnitt der Ausführungsform des Trägers
- 21b: Abschnitt der Ausführungsform des Trägers
- 3: erstes Kontaktpad
- 4: zweites Kontaktpad
- 5: elektrisch leitfähige Struktur
- 6: erster Kontaktleiter
- 6a: erster Abschnitt des ersten Kontaktleiters
- 6b: zweiter Abschnitt des ersten Kontaktleiters
- 61: erste Oberfläche des ersten Kontaktleiters
- 62: zweite Oberfläche des ersten Kontaktleiters
- 63: Durchgangsöffnung
- 7: zweiter Kontaktleiter
- 7a: erster Abschnitt des zweiten Kontaktleiters
- 7b: zweiter Abschnitt des zweiten Kontaktleiters
- 71: erste Oberfläche des zweiten Kontaktleiters
- 72: zweite Oberfläche des zweiten Kontaktleiters
- 73: Durchgangsöffnung
- 8: Beschichtung (ENIG)
- 9: drittes Kontaktpad
- 10: dritter Kontaktleiter
- 10a: erster Abschnitt des dritten Kontaktleiters
- 10b: zweiter Abschnitt des dritten Kontaktleiters
- 103: Durchgangsöffnung
- 11: Lotschicht
- 12: Laser
- 13: Kontaktstelle
- 14: Schlitzungen

## Patentansprüche

1. Verbindungselement (1) für eine elektronische Bauelementanordnung, aufweisend:
einen Träger (2) mit einer ersten Hauptoberfläche (2a) und einer der ersten Hauptoberfläche (2a) gegenüberliegenden zweiten Hauptoberfläche (2b);
ein auf einer der Hauptoberflächen (2a, 2b) des Trägers (2) angeordnetes erstes Kontaktpad (3) und ein auf einer der Hauptoberflächen (2a, 2b) des Trägers (2) angeordnetes zweites Kontaktpad (4);
eine das erste Kontaktpad (3) und das zweite Kontaktpad (4) elektrisch leitend miteinander verbindende elektrisch leitfähige Struktur (5); und
einen ersten Kontaktleiter (6) mit einer ersten Oberfläche (61) und einer der ersten Oberfläche (61) gegenüberliegenden zweiten Oberfläche (62);
wobei ein erster Abschnitt (6a) der ersten Oberfläche (61) des ersten Kontaktleiters (6) mittels einer Lotschicht (11) mit dem ersten Kontaktpad (3) elektrisch leitend verbunden ist; und
wobei der erste Kontaktleiter (6) in einem zweiten Abschnitt (6b) seiner ersten Oberfläche (61) und/oder auf seiner zweiten Oberfläche (62) zum Ausbilden einer Schweißverbindung ausgestaltet ist.

2. Verbindungselement nach Anspruch 1, **dadurch gekennzeichnet, dass**
der erste Abschnitt (6a) des ersten Kontaktleiters (6) über dem ersten Kontaktpad (3) angeordnet und in dem ersten Abschnitt (6a) die erste Oberfläche (61) des ersten Kontaktleiters (6) dem ersten Kontaktpad (3) zugewandt ist; und
der zweite Abschnitt (6b) der ersten Oberfläche (61) des ersten Kontaktleiters (6) nicht über dem ersten Kontaktpad (3) angeordnet und/oder dem ersten Kontaktpad (3) nicht zugewandt ist.

3. Verbindungselement nach einem der Ansprüche 1 oder 2, ferner aufweisend:
einen zweiten Kontaktleiter (7) mit einer ersten Oberfläche (71) und einer der ersten Oberfläche (71) gegenüberliegenden zweiten Oberfläche (72);
wobei ein erster Abschnitt (7a) der ersten Oberfläche (71) des zweiten Kontaktleiters (7) über eine Lotschicht mit dem zweiten Kontaktpad (4) elektrisch leitend verbunden ist; und
wobei der zweite Kontaktleiter (7) in einem zweiten Abschnitt (7b) seiner ersten Oberfläche (71) und/oder auf seiner zweiten Oberfläche (72) zum Ausbilden einer Schweißverbindung ausgestaltet ist.

4. Verbindungselement nach einem der Ansprüche 1 bis 3, **dadurch gekennzeichnet, dass** der erste Kontaktleiter (6) aus Nickel, Kupfer, Tantal, Niob, Aluminium oder Legierungen davon gebildet ist oder in einem zweiten Abschnitt (6b) seiner ersten Oberfläche (61) und/oder auf seiner zweiten Oberfläche (62) eine Beschichtung aus Nickel, Kupfer, Tantal, Niob, Aluminium oder Legierungen davon aufweist.

5. Verbindungselement nach einem der Ansprüche 1 bis 4, **dadurch gekennzeichnet, dass** der erste Kontaktleiter (6) als ein flaches Metallband, eine Metallfolie oder ein Metallquader ausgebildet ist.

6. Verbindungselement nach einem der Ansprüche 1 bis 5, **dadurch gekennzeichnet, dass** in dem zweiten Abschnitt (6b) des ersten Kontaktleiters (6) eine Durchgangsöffnung (63) von der ersten Oberfläche (61) zu der zweiten Oberfläche (62) des ersten Kontaktleiters (6) angeordnet ist.

7. Verbindungselement nach einem der Ansprüche 1 bis 6, **dadurch gekennzeichnet, dass** der Träger (2) ein flexibler Schaltungsträger ist.

8. Verbindungselement nach Anspruch 7, **dadurch gekennzeichnet, dass** die elektrisch leitfähige Struktur (5) zwischen den Hauptoberflächen (2a, 2b) des Trägers (2) angeordnet ist und/oder als eine zwischen dielektrischen dünnen Schichten (2a, 2b) des Trägers (2) angeordnete Metallstruktur (5) ausgebildet ist.

9. Verbindungselement nach einem der Ansprüche 1 bis 8, **dadurch gekennzeichnet, dass** der erste Abschnitt (6a) der ersten Oberfläche (61) des ersten Kontaktleiters (6) und der zweite Abschnitt (6b) der ersten Oberfläche (61) des ersten Kontaktleiters (6) einen spitzen, stumpfen oder rechten Winkel einschließen.

10. Verbindungselement nach einem der Ansprüche 1 bis 9, **dadurch gekennzeichnet, dass** eine Beschichtung (8) zur Verbesserung der Benetzbarkeit mit dem Lotmaterial zumindest eines von HAL, ENIG, ImAg, SnPb, galvanisch NiAu und Karbon aufweist.

11. Verfahren zum Herstellen eines Verbindungselements (1) für eine elektronische Bauelementanordnung, aufweisend die Verfahrensschritte:
Bereitstellen eines Trägers (2) mit einer ersten Hauptoberfläche (2a) und einer der ersten Hauptoberfläche (2a) gegenüberliegenden zweiten Hauptoberfläche (2b), mit einem auf einer der Hauptoberflächen (2a, 2b) des Trägers (2) angeordneten ersten Kontaktpad (3) und einem auf einer der Hauptoberflächen (2a, 2b) des Trägers (2) angeordneten zweiten Kontaktpad (4) und mit einer das erste Kontaktpad (3) und das zweite Kontaktpad (4) elektrisch leitend miteinander verbindenden elektrisch leitfähigen Struktur (5);
Bereitstellen eines ersten Kontaktleiters (6) mit einer ersten Oberfläche (61) und einer der ersten Oberfläche (61) gegenüberliegenden zweiten Oberfläche (62), der in einem zweiten Abschnitt (6b) der ersten Oberfläche (61) und/oder auf der zweiten Oberfläche (62) zum Ausbilden einer Schweißverbindung ausgestaltet ist;
Bestücken des Trägers (2) mit dem ersten Kontaktleiter (6) und dabei Anordnen des ersten Kontaktleiters (6) auf dem Träger (2) mit einem ersten Abschnitt (6a) des ersten Kontaktleiters (6) über dem ersten Kontaktpad (3); und
Verlöten des ersten Kontaktleiters (6) durch Ausbilden einer Lotschicht (11) zwischen dem ersten Abschnitt (6a) der ersten Oberfläche (61) des ersten Kontaktleiters (6) und dem ersten Kontaktpad (3) zum elektrisch leitenden Verbinden von erstem Kontaktleiter (6) und erstem Kontaktpad (3).

12. Verfahren nach Anspruch 11, ferner aufweisend die Verfahrensschritte:
Bestücken des Trägers (2) mit dem ersten Kontaktleiter (6) und dabei Anordnen des ersten Kontaktleiters (6) auf dem Träger (2), so dass der erste Abschnitt (6a) des ersten Kontaktleiters (6) über dem ersten Kontaktpad (3) angeordnet und in dem ersten Abschnitt (6a) die erste Oberfläche (61) des ersten Kontaktleiters (6) dem ersten Kontaktpad (3) zugewandt ist; und
Umformen des ersten Kontaktleiters (6), so dass der zweite Abschnitt (6b) der ersten Oberfläche (61) des ersten Kontaktleiters (6) dem ersten Kontaktpad (3) nicht zugewandt ist.

13. Verfahren zum Herstellen einer elektronischen Bauelementanordnung, aufweisend die Verfahrensschritte:
Bereitstellen eines Trägers (2) mit einer ersten Hauptoberfläche (2a) und einer der ersten Hauptoberfläche (2a) gegenüberliegenden zweiten Hauptoberfläche (2b), mit einem auf einer der Hauptoberflächen (2a, 2b) des Trägers (2) angeordneten ersten Kontaktpad (3) und einem auf einer der Hauptoberflächen (2a, 2b) des Trägers (2) angeordneten zweiten Kontaktpad (4) und mit einer das erste Kontaktpad (3) und das zweite Kontaktpad (4) elektrisch leitend miteinander verbindenden elektrisch leitfähigen Struktur (5);
Bereitstellen eines ersten Kontaktleiters (6) mit einer ersten Oberfläche (61) und einer der ersten Oberfläche (61) gegenüberliegenden zweiten Oberfläche (62), der in einem zweiten Abschnitt (6b) der ersten Oberfläche (61) und/oder auf der zweiten Oberfläche (62) zum Ausbilden einer Schweißverbindung ausgestaltet ist;
Bestücken des Trägers (2) mit dem ersten Kontaktleiter (6) und dabei Anordnen des ersten Kontaktleiters (6) auf dem Träger (6) mit einem ersten Abschnitt (6a) des ersten Kontaktleiters (6a) über dem ersten Kontaktpad (3);
Verlöten des ersten Kontaktleiters (6) durch Ausbilden einer Lotschicht (11) zwischen dem ersten Abschnitt (6a) der ersten Oberfläche (61) des ersten Kontaktleiters (6) und dem ersten Kontaktpad (3) zum elektrisch leitenden Verbinden von erstem Kontaktleiter (6) und erstem Kontaktpad (3);
Bereitstellen eines elektronischen Bauelements mit einer Kontaktstelle (13), die zum Ausbilden einer Schweißverbindung ausgestaltet ist; und
Verschweißen des zweiten Abschnitts (6b) der ersten Oberfläche (61) des ersten Kontaktleiters (6) oder der zweiten Oberfläche (62) des ersten Kontaktleiters (6) mit der Kontaktstelle (13) des elektronischen Bauelements.

14. Verfahren nach Anspruch 13, ferner aufweisend die Verfahrensschritte:
Bereitstellen eines zweiten Kontaktleiters (7) mit einer ersten Oberfläche (71) und einer der ersten Oberfläche (71) gegenüberliegenden zweiten Oberfläche (72), der in einem zweiten Abschnitt (7b) der ersten Oberfläche (71) und/oder auf der zweiten Oberfläche (72) zum Ausbilden einer Schweißverbindung ausgestaltet ist;
Bestücken des Trägers (2) mit dem zweiten Kontaktleiter (7) und dabei Anordnen des zweiten Kontaktleiters (7) auf dem Träger (2) mit einem ersten Abschnitt (7a) des zweiten Kontaktleiters (7) über dem zweiten Kontaktpad (4);
Verlöten des zweiten Kontaktleiters (7) durch Ausbilden einer Lotschicht zwischen dem ersten Abschnitt (7a) der ersten Oberfläche (71) des zweiten Kontaktleiters (7) und dem zweiten Kontaktpad (4) zum elektrisch leitenden Verbinden von zweitem Kontaktleiter (7) und zweitem Kontaktpad (4);
Bereitstellen einer Strom- oder Spannungsquelle mit einem Kontaktpin, der zum Ausbilden einer Schweißverbindung, Lötverbindung oder Steckverbindung ausgestaltet ist; und
Verbinden des zweiten Abschnitts (7b) der ersten Oberfläche (71) des zweiten Kontaktleiters (7) oder der zweiten Oberfläche (72) des zweiten Kontaktleiters (7) mit dem Kontaktpin der Strom- oder Spannungsquelle zum Herstellen einer elektrisch leitfähigen Verbindung zwischen Kontaktpin und zweitem Kontaktleiter (7).

15. Verfahren nach Anspruch 13 oder 14, ferner aufweisend die Verfahrensschritte:
Bereitstellen eines ersten Kontaktleiters (6) mit einer in dessen zweiten Abschnitt (6b) angeordneten Durchgangsöffnung (63) von der ersten Oberfläche (61) zu der zweiten Oberfläche (62) des ersten Kontaktleiters (6); und
Laserverschweißen des zweiten Abschnitts (6b) der ersten Oberfläche (61) des ersten Kontaktleiters oder der zweiten Oberfläche (62) des ersten Kontaktleiters (6) mit der Kontaktstelle (13) des elektronischen Bauelements durch die Durchgangsöffnung (63) hindurch.
